# EUROPEAN PATENT APPLICATION

(11) **EP 4 773 791 A1**
(43) Date of publication of application: **08.07.2026**
(21) Application number: 24870814.1
(22) Date of filing: 25.09.2024
(51) Int. Cl.: H10N 70/00

(54) **PHASE CHANGE MATERIAL, PHASE CHANGE STORAGE CHIP, STORAGE DEVICE, AND ELECTRONIC DEVICE**

(30) Priority: 28.09.2023 CN 202311290353; 19.03.2024 CN 202410316618
(71) Applicant: HUAWEI TECHNOLOGIES CO., LTD., Shenzhen 518129 (CN)
(72) Inventor: LI, Xiang, Shenzhen, Guangdong 518129 (CN); CHEN, Xin, Shenzhen, Guangdong 518129 (CN); CHEN, Wei, Shenzhen, Guangdong 518129 (CN); YANG, Zhe, Shenzhen, Guangdong 518129 (CN); ZHANG, Yu, Shenzhen, Guangdong 518129 (CN); TONG, Hao, Shenzhen, Guangdong 518129 (CN)
(74) Representative: Grünecker Patent- und Rechtsanwälte PartG mbB
(86) International application number: PCT/CN2024/121208
(87) International publication number: WO 2025/067270

(57) **Abstract**

This disclosure discloses a phase change material, a phase change storage chip, a storage device, and an electronic device, and belongs to the field of semiconductor storage technologies. The phase change material includes a Ge-Sb-Te phase change base material and a first doping element and a second doping element that are doped into the Ge-Sb-Te phase change base material. The first doping element includes an element Hf, and an atomic percentage of the first doping element is 1.5% to 6.5%. The second doping element includes at least one of an element N, an element C, an element In, and an element Ga, and an atomic percentage of the second doping element is 1.0% to 5%. The phase change material has a high adhesive force, and also enables a phase change component to have a large read window, a long life, and other performance.

## Description

This application claims priorities to Chinese Patent Application No. 202311290353.5, filed on September 28, 2023, and entitled "PHASE CHANGE MEMORY", and to Chinese Patent Application No. 202410316618.2, filed on March 19, 2024, and entitled "PHASE CHANGE MATERIAL, PHASE CHANGE STORAGE CHIP, STORAGE DEVICE, AND ELECTRONIC DEVICE", both of which are incorporated herein by reference in their entireties.

### TECHNICAL FIELD

This disclosure relates to the field of semiconductor storage technologies, and in particular, to a phase change material, a phase change storage chip, a storage device, and an electronic device.

### BACKGROUND

A phase change memory (PCM) has advantages such as a low delay and a long fatigue life, and uses a phase change material as a storage medium. The phase change material presents a low resistivity in a crystalline state, and presents a high resistivity in an amorphous state. The phase change memory implements data storage and program/erase based on a resistance difference between the crystalline state and the amorphous state of the phase change material.

In a conventional technology, the phase change memory includes a plurality of phase change storage units, and the phase change storage unit includes a phase change material layer and barrier layers located on two sides of the phase change material layer. Such a sandwich structure including the phase change material layer and the barrier layers bears a large stress in a process procedure like annealing and etching. Consequently, interface delamination may occur between the phase change material layer and another functional layer like the barrier layer. Consequently, a phase change storage unit in which a delamination area is located cannot be used normally, and material particles that fall off due to delamination also have adverse impact on the device and the like.

It can be learned that it is necessary to improve an interface adhesive force between the phase change material layer and another functional layer in the phase change memory.

### SUMMARY

According to one aspect, a phase change material is provided. The phase change material includes a Ge-Sb-Te phase change base material, and a first doping element and a second doping element that are doped into the Ge-Sb-Te phase change base material; the first doping element includes an element Hf, and an atomic percentage of the first doping element in the phase change material is 1.5% to 6.5%; and the second doping element includes at least one of an element N, an element C, an element In, and an element Ga, and an atomic percentage of the second doping element in the phase change material is 1.0% to 5%.

According to the phase change material provided in this embodiment of this disclosure, at least one of the element N, the element C, the element In, and the element Ga is further doped into the Ge-Sb-Te phase change base material doped with the element Hf, so that an adhesive force of a phase change material layer can be enhanced, the phase change material layer is closely combined with another neighboring functional layer, an interface delamination probability is reduced, and a product yield of a phase change storage chip is increased, to avoid pollution and interference to a production line and production equipment. Particularly, a doping amount of the element Hf is 1.5% to 6.5%, and a doping amount of at least one of the element N, the element C, the element In, and the element Ga is 1.0% to 5.0%. This improves the adhesive force of the phase change material layer, and also helps enable a phase change component to have a large read window and a long life.

In some possible implementations, the phase change material further includes a third doping element, and the third doping element includes at least one of an element O, an element Si, an element B, an element Sn, an element Bi, an element Cd, an element Pb, an element Zr, an element Zn, an element Cr, an element Al, an element Sc, an element Y, an element Ta, an element Ti, an element Er, an element Lu, an element Ho, an element Tm, an element Dy, an element Tb, an element Ca, an element Nd, an element Pr, an element Yb, an element Ca, and an element Ce. An objective of optimizing comprehensive performance of the phase change storage component can also be achieved by further introducing a third doping element of a specific content into the phase change material.

In some possible implementations, a chemical formula of the Ge-Sb-Te phase change base material is as follows: (GeTe₁₋ₐ)ₓ(Sb₂Te_{3-b})₁₋ₓ, where x is an atomic percentage and 0<x<1, a and b are parameters related to an atomic quantity ratio, 0<a≤1, 0<b≤3, and a=1 and b=3 do not coexist; or (GeTe_{1-c})ₓ(Sb_{y}Te_{1-d})₁₋ₓ where x is an atomic percentage and 0<x<1, y, c, and d are parameters related to an atomic quantity ratio, y≥2, 0<c≤1, 0<d≤1, and c=1 and d=1 do not coexist.

The chemical formula of the Ge-Sb-Te phase change base material is described above, to ensure that the adhesive force of the phase change material layer is stronger than that of a phase change material layer corresponding to the Ge-Sb-Te phase change base material.

According to another aspect, a phase change material is provided. The phase change material includes a Ge-Sb-Te phase change base material, and a first doping element and a second doping element that are doped into the Ge-Sb-Te phase change base material; the first doping element includes an element Hf, and an atomic percentage of the first doping element in the phase change material is 1.5% to 7%; the second doping element includes at least one of an element N, an element C, an element In, and an element Ga, and an atomic percentage of the second doping element in the phase change material is 1.0% to 7%; and a sum of the atomic percentage of the first doping element and the atomic percentage of the second doping element is greater than 4% and less than 10%.

According to this type of phase change material provided in this embodiment of this disclosure, at least one of the element N, the element C, the element In, and the element Ga is further doped into the Ge-Sb-Te phase change base material doped with the element Hf, so that an adhesive force of a phase change material layer can be enhanced, the phase change material layer is closely combined with another neighboring functional layer, an interface delamination probability is reduced, and a product yield of a phase change storage chip is increased, to avoid pollution and interference to a production line and production equipment. Particularly, a doping amount of the element Hf is 1.5% to 7%, a doping amount of at least one of the element N, the element C, the element In, and the element Ga is 1.0% to 7%, and the sum of the atomic percentages of the two doping elements is greater than 4% and less than 10%. This improves the adhesive force of the phase change material layer, and also helps enable the phase change component to have a large read window, a long life, and cycle stability.

In some possible implementations, the phase change material further includes a third doping element, and the third doping element includes at least one of an element O, an element Si, an element B, an element Sn, an element Bi, an element Cd, an element Pb, an element Zr, an element Zn, an element Cr, an element Al, an element Sc, an element Y, an element Ta, an element Ti, an element Er, an element Lu, an element Ho, an element Tm, an element Dy, an element Tb, an element Ca, an element Nd, an element Pr, an element Yb, an element Ca, and an element Ce. An objective of optimizing comprehensive performance of the phase change storage component can also be achieved by further introducing a third doping element of a specific content into the phase change material.

In some possible implementations, a chemical formula of the Ge-Sb-Te phase change base material is as follows: (GeTe₁₋ₐ)ₓ(Sb₂Te_{3-b})₁₋ₓ, where x is an atomic percentage and 0<x<1, a and b are parameters related to an atomic quantity ratio, 0<a≤1, 0<b≤3, and a=1 and b=3 do not coexist; or (GeTe_{1-c})ₓ(Sb_{y}Te_{1-d})₁₋ₓ, where x is an atomic percentage and 0<x<1, y, c, and d are parameters related to an atomic quantity ratio, y≥2, 0<c<1, 0<d≤1, and c=1 and d=1 do not coexist.

The chemical formula of the Ge-Sb-Te phase change base material is described above, to ensure that the adhesive force of the phase change material layer is stronger than that of a phase change material layer corresponding to the Ge-Sb-Te phase change base material.

Further, a chemical formula of the Ge-Sb-Te phase change base material is as follows: (GeTe₁₋ₐ)ₓ(Sb₂Te_{3-b})₁₋ₓ and 0.2<x≤0.4, or (GeTe_{1-c})ₓ(Sb_{y}Te_{1-d})₁₋ₓ and 0.2<x≤0.4.

In this embodiment of this disclosure, the chemical formula for limiting the Ge-Sb-Te phase change base material is further shown above, to help enable the phase change component to have both a low delay and a long life, and it is ensured that the phase change material layer has high adhesive force.

According to still another aspect, a phase change storage chip is provided. The phase change storage chip includes a plurality of phase change storage units, the phase change storage unit includes a phase change material layer, and the phase change material layer is prepared by using any one of the foregoing phase change materials.

The phase change storage chip provided in this embodiment of this disclosure is prepared based on the phase change material layer of the phase change storage chip by the phase change material provided in this embodiment of this disclosure, so that the phase change storage chip has all advantages of the phase change material provided in this embodiment of this disclosure.

In some possible implementations, the phase change storage unit further includes an adhesive layer, the adhesive layer is arranged on at least one surface of the phase change material layer in a stacked manner, and the adhesive layer is configured to increase an adhesive force between the phase change material layer and a neighboring functional layer.

In the phase change storage chip provided in this embodiment of this disclosure, not only the phase change material is improved, but also a structure of the phase change storage chip is improved to add the adhesive layer to the phase change storage chip, to further improve the adhesive force between the phase change material layer and the neighboring functional layer, significantly reduce an interface delamination probability, increase a product yield of the phase change storage unit, and avoid pollution, interference, and the like to a production line.

In some possible implementations, an adhesive layer raw material used by the adhesive layer includes at least one of a nitride of a target element and a carbide of the target element.

The target element is selected from at least one of an element W, an element Ti, an element Ge, an element Ta, an element Hf, an element In, an element Ga, an element Al, an element Cu, an element Co, and an element Mo.

In some possible implementations, an adhesive layer raw material used by the adhesive layer includes a Ge-Sb-Te phase change material doped with a fourth doping element, and the adhesive layer raw material is different from the phase change material.

The fourth doping element is selected from at least one of an element Hf, an element N, an element C, an element In, and an element Ga, and an atomic percentage of the fourth doping element in the adhesive layer raw material is 0.01% to 20%.

In some possible implementations, the phase change storage unit further includes a barrier layer, and the adhesive layer is located between the phase change material layer and the barrier layer and is configured to increase an adhesive force between the phase change material layer and the barrier layer.

In some possible implementations, a barrier layer material used by the barrier layer includes at least one of single element materials, nitrides, and carbides of an element W, an element Ti, an element Ge, an element Ta, an element Hf, an element In, an element Ga, an element Al, an element Cu, an element Co, and an element Mo.

In some possible implementations, the phase change storage unit further includes an electrode layer, and the adhesive layer is located between the phase change material layer and the electrode layer and is configured to increase an adhesive force between the phase change material layer and the electrode layer.

In some possible implementations, the phase change storage chip further includes a plurality of selector units, and the selector unit and the phase change storage unit are arranged in series.

In some possible implementations, the selector unit includes a selector layer, and a selector material used by the selector layer includes at least one of an S-series selector material, an Se-series selector material, and a Te-series selector material.

In some possible implementations, the selector material further includes a fifth doping element, and the fifth doping element is selected from at least one of an element B, an element Al, an element Ga, an element In, an element C, an element Si, an element Ge, an element Sn, an element N, an element P, an element As, an element Sb, an element Bi, an element O, an element Au, an element Hf, an element Pd, an element Cu, an element Co, an element Ag, an element Pt, an element Sc, an element Ti, and an element Ta.

According to yet another aspect, an embodiment of this disclosure provides a storage device. The storage device includes a controller and at least one phase change storage chip described above, and the controller is configured to store data into the phase change storage chip.

The storage device (which may also be referred to as a memory) may be configured to store various types of data. The data may be contact data, phone book data, a message, a picture, a video, or the like, or may be instruction data.

According to still yet another aspect, an embodiment of this disclosure provides an electronic device. The electronic device includes a processor and the foregoing storage device, and the processor is configured to store data generated by the electronic device into the storage device.

The electronic device includes but is not limited to: a computer, a mobile phone, a music play device, a digital broadcasting device, a message transceiver device, a game control device, a medical device, a fitness device, a personal digital assistant, and the like.

### BRIEF DESCRIPTION OF DRAWINGS

FIG. 1 is a diagram of a process of interface delamination between a phase change material layer and a barrier layer in the conventional technology;
FIG. 2 is a diagram of mean square displacement of an element Hf in a Ge-Sb-Te phase change base material;
FIG. 3 is a diagram of mean square displacement of an element In in a Ge-Sb-Te phase change base material;
FIG. 4 is a diagram of mean square displacement of an element Ga in a Ge-Sb-Te phase change base material;
FIG. 5 is a diagram of a structure of an example of a phase change storage unit according to an embodiment of this disclosure;
FIG. 6 is a diagram of a structure of another example of a phase change storage unit according to an embodiment of this disclosure;
FIG. 7 is a diagram of a structure of still another example of a phase change storage unit according to an embodiment of this disclosure;
FIG. 8 is a diagram of a structure of yet another example of a phase change storage unit according to an embodiment of this disclosure;
FIG. 9 is a diagram of a structure of an example of a phase change storage chip according to an embodiment of this disclosure;
FIG. 10 is a diagram of a structure of another example of a phase change storage chip according to an embodiment of this disclosure;
FIG. 11 is a diagram of a structure of still another example of a phase change storage chip according to an embodiment of this disclosure;
FIG. 12 is a diagram of a structure of yet another example of a phase change storage chip according to an embodiment of this disclosure;
FIG. 13 is an array diagram of an example of a phase change storage chip according to an embodiment of this disclosure;
FIG. 14 is a diagram of a first preparation step of a phase change storage chip according to Embodiment 1;
FIG. 15 is a diagram of a second preparation step of a phase change storage chip according to Embodiment 1;
FIG. 16 is a diagram of a third preparation step of a phase change storage chip according to Embodiment 1;
FIG. 17 is a diagram of a fourth preparation step of a phase change storage chip according to Embodiment 1;
FIG. 18 is a diagram of a fifth preparation step of a phase change storage chip according to Embodiment 1;
FIG. 19 is a diagram of a sixth preparation step of a phase change storage chip according to Embodiment 1;
FIG. 20 is a diagram of a seventh preparation step of a phase change storage chip according to Embodiment 1;
FIG. 21 is a diagram of an eighth preparation step of a phase change storage chip according to Embodiment 1;
FIG. 22 is a diagram of a ninth preparation step of a phase change storage chip according to Embodiment 1;
FIG. 23 is a diagram of a tenth preparation step of a phase change storage chip according to Embodiment 1; and
FIG. 24 is a diagram of a relationship between a life of a phase change storage chip and resistance in a SET state according to an embodiment of this disclosure.

### Reference numerals:

001: Storage subunit; 002: Word line; 003: Bit line; 004: Substrate; 005: Mask layer; 100: Phase change material layer; 200: Adhesive layer; 300: Barrier layer; 400: Insulation layer; 401: First insulation layer; 402: Second insulation layer; 403: Third insulation layer; 404: Fourth insulation layer; 501: Top electrode; 502: Bottom electrode; 503: Intermediate electrode; 600: Selector layer; 701: First groove; 702: Second groove; 703: Third groove.

### DESCRIPTION OF EMBODIMENTS

In descriptions of embodiments of this disclosure, the terms "vertical direction", "horizontal direction", "top", "bottom", "up", "down", and the like indicate an orientation or a position relationship based on an orientation or a position relationship shown in the accompanying drawings, and are merely intended to facilitate description of embodiments of this disclosure and simplified description, but do not indicate or imply that a specified apparatus or element needs to have a specific orientation and be constructed and operated in a specific orientation. Therefore, the terms cannot be understood as a limitation on embodiments of this disclosure. When a product is placed in different postures, an orientation may change, for example, "top" and "bottom" may be interchanged.

A phase change memory (Phase change memory, PCM), also referred to as a phase change storage chip, is a solid-state semiconductor non-volatile memory, and uses a phase change material as a storage medium. The phase change material can perform reversible conversion between a crystalline state and an amorphous state. The phase change memory stores data "0" and "1" by using a difference between a high resistivity and a low resistivity that correspond to the phase change material in the amorphous state and the crystalline state.

A working procedure of the phase change memory includes an erase operation (SET) procedure and a write operation (RESET) procedure. The SET procedure means that a wide and weak electric pulse is applied to heat the phase change material, so that a temperature of the phase change material is increased to a temperature between a crystallization temperature and a melting temperature, the phase change material is crystallized into an ordered state, and the crystalline state with the low resistivity is formed, to store data "0". The RESET procedure means that a narrow and strong electric pulse is applied to heat the phase change material, so that a temperature of the phase change material is increased to a temperature higher than a melting temperature, and the phase change material is melted into an unordered state. Subsequently, after a rapid cooling quenching procedure, the phase change material directly enters the amorphous state with the high resistivity from a molten state, to store data "1".

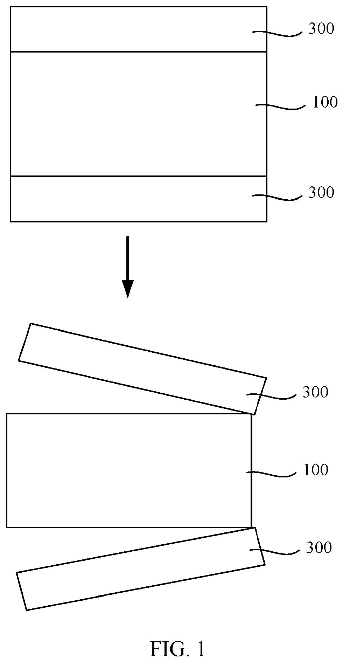

In the conventional technology, the phase change memory includes a plurality of phase change storage units. As shown in FIG. 1, the phase change storage unit includes a phase change material layer 100 and barrier layers 300 located on two sides of the phase change material layer 100. In a procedure of preparing the phase change memory, such a sandwich structure including the phase change material layer 100 and the barrier layers 300 undergoes many processes such as annealing, graphics, etching, and protective layer covering, and bears a large stress. Consequently, interface delamination may occur between the phase change material layer 100 and another functional layer like the barrier layer 300 (refer to FIG. 1). Consequently, a phase change storage unit in which a delamination area is located cannot be normally used (for example, interface delamination occurs between the phase change material layer and the barrier layer, and the phase change material layer and the barrier layer cannot be combined), and particle materials that fall off due to delamination also have adverse impact on production equipment (for example, polluting a production line and interfering with normal running of the equipment). It can be learned that it is necessary to improve an interface adhesive force between the phase change material layer and another functional layer.

A first embodiment of this disclosure provides a phase change material. The phase change material includes a Ge-Sb-Te phase change base material and a first doping element and a second doping element that are doped into the Ge-Sb-Te phase change base material. The first doping element includes an element Hf, and an atomic percentage of the first doping element in the phase change material is 1.5% to 6.5%. The second doping element includes at least one of an element N, an element C, an element In, and an element Ga, and an atomic percentage of the second doping element in the phase change material is 1.0% to 5.0%.

For example, some examples of the atomic percentage of the first doping element Hf in the phase change material include but are not limited to 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, and the like.

For example, some examples of the atomic percentage of the second doping element in the phase change material include but are not limited to 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, and the like.

The second doping element may be one of the element N, the element C, the element In, and the element Ga. For example, the second doping element is the element N, the element C, the element In, or the element Ga, or the second doping element may be a combination of any two or any three of the element N, the element C, the element In, and the element Ga, or include all of the four elements.

According to the phase change material provided in this embodiment of this disclosure, the Ge-Sb-Te phase change base material is doped with the element Hf and at least one of the element N, the element C, the element In, and the element Ga, so that the adhesive force between the phase change material layer and another functional layer can be improved. The following separately describes an improvement principle of the adhesive force between the phase change material layer and another functional layer.
(1) When the second doping element is the element N or the element C, the element N or the element C can be bonded with the element Hf, so that an HfN compound or an HfC compound is introduced into the phase change material. A lattice constant of the HfN compound or the HfC compound does not match a lattice constant of the Ge-Sb-Te phase change base material (for example, the lattice constant of the HfN compound is 0.452 nm, the lattice constant of the HfC compound is 0.463 nm, and both do not match the lattice constant of the Ge-Sb-Te phase change base material (for example, the lattice constant of GelSb4Te6 is 0.612 nm)). Therefore, an additional grain boundary is introduced, a grain size of the phase change material is reduced, roughness of the phase change material is reduced, and a contact area and a bonding force between the phase change material layer and another functional layer are increased, to increase the adhesive force of the phase change material layer.

It is further found through research that when an atomic percentage of the element N or the element C is 1.0% to 5.0%, it can be further ensured that a phase change component has a large read window. A related principle is shown as follows: For an operation of a 1S1R-type phase change storage chip, a threshold voltage for opening a selector unit and a crystalline-state phase change storage unit is VtS, a threshold voltage for opening the selector unit and an amorphous-state phase change storage unit is VtR, and the read window is VtR-VtS. It can be learned that a size of the read window is in direct proportion to a difference between high resistance and low resistance of the phase change material layer.

On one hand, the HfN compound and the HfC compound can improve high resistance of the phase change material. This helps increase the read window of the phase change component. On the other hand, if Hf is separately doped into the Ge-Sb-Te phase change base material, because Hf is in contact with O or another substance with an oxidation characteristic in a process preparation procedure, Hf is easily oxidized to form HfOx, and a resistivity of HfOx is greater than a resistivity of the phase change material. This causes low resistance of the phase change material to increase to some extent, and consequently, the read window of the phase change component is reduced. However, melting points of the HfN compound and the HfC compound are respectively 3310°C and 3900°C, have high chemical stability, and are not easy to react with other elements such as O, so that an oxidation probability of the element Hf is reduced, and it is ensured that the phase change component has a large read window.

However, impact of the element N or the element C on the read window of the phase change component is related to a doping amount of the element N or the element C in the phase change material. In this embodiment of this disclosure, it is proved by using a related experiment that when an atomic percentage of the element Hf is greater than 6.5% (not in a limited range of 1.5% to 6.5%), and an atomic percentage of the element N or the element C is greater than 5.0% (not in a limited range of 1% to 5%), the read window of the phase change component deteriorates.

For example, the foregoing "related experiment" is shown as follows.

An embodiment of this disclosure provides such a type of phase change material, where a Ge-Sb-Te phase change base material of the phase change material is doped with an element Hf and an element N, and a ratio between atomic percentage of elements in a chemical formula of the Ge-Sb-Te phase change base material meets: Ge:Sb:Te=1:4:6 (which may be referred to as GelSb4Te6, GeSbTe146, or GST146 for short). When other parameters are kept quantitative, low resistance corresponding to a crystalline state of the phase change material layer and high resistance corresponding to an amorphous state of the phase change material layer are separately tested by changing doping amounts of the element Hf and the element N. For related test parameters and test results, refer to Table 1.

**Table 1**

| Phase change material sequence number | Atomic percentage of the element Hf | Atomic percentage of the element N | High resistance of the phase change material layer (Ω) | Low resistance of the phase change material layer (Ω) | Crystallization temperature of the phase change material (°C) |
|---|---|---|---|---|---|
| 1 | 4% | 0% | 6.7 M | 400 | 205 |
| 2 | 6.5% | 5% | 31.7 M | 56.8 k | 240 |
| 3 | 4% | 4% | 27.2 M | 9.1 k | 235 |
| 4 | 2% | 2% | 10 M | 420 | 210 |
| 5 | 4.7% | 2.9% | 23.3 M | 4.6 k | 230 |
| 6 | 3.6% | 2.8% | 18.4 M | 3.3 k | 230 |

It can be learned from the phase change material 1 and the phase change material 3 in Table 1 that, the Ge-Sb-Te phase change base material doped with the element Hf is further doped with the element N, to improve the high resistance of the phase change material layer, to improve a read window size.

With reference to the phase change material 2 in Table 1, it can be learned that, when doping concentration of the element Hf is 6.5%, and doping concentration of the element N is 5%, a crystallization temperature of the phase change material 2 is increased by 35°C compared with that of the phase change material 1 (which is not doped with N) in Table 1, low resistance of the phase change material 2 is increased more than 100 times compared with that of the phase change material 4 (Hf2%+N2%) in Table 1, and the low resistance of the phase change material 2 is increased more than five times compared with that of the phase change material 3 (Hf4%+N4%) in Table 1. This causes a phenomenon that the read window deteriorates to some extent. It can be learned that, when the atomic percentage of the element Hf is greater than 6.5%, and the atomic percentage of the element N or the element C is greater than 5.0%, the crystallization temperature is further increased. In this way, under a specific back-end-of-line heat treatment condition, the low resistance of the phase change material layer increases, and the read window of the phase change component decreases. It can be learned that, in this embodiment of this disclosure, the atomic percentage of the element Hf is 1.5% to 6.5%, and the atomic percentage of the element N or the element C is 1% to 5%, which is important to ensure that the phase change component has a large read window.

In addition, as mentioned above, the melting points of the HfN compound and the HfC compound are respectively 3310°C and 3900°C, and have high chemical stability.

It can be learned that the high melting points of the HfN compound and the HfC compound enable the HfN compound and the HfC compound to be stably retained in a melting procedure of RESET (about 600°C) of the phase change material, and stable HfN compound and HfC compound clusters hinder element segregation and phase separation of the GeSbTe phase change base material, which are both conducive to making the phase change component have a long life characteristic.

(2) When the second doping element is the element In or the element Ga, the element In and the element Ga are likely to form metal-metal bonds with a metal element like the element Hf, to enhance a bonding force between the phase change material layer and another functional layer. This is because the element In and the element Ga have a low melting point (<200°C) relative to another solid-state metal element at a room temperature, so that the element In and the element Ga have a strong diffusion capability. Therefore, the element In and the element Ga are conducive to forming metal-metal bonds with the metal element in another functional layer, to form an alloy, to improve the adhesive force between the phase change material and another functional layer including the metal element. For example, the "another functional layer" herein may be a barrier layer or an adhesive layer in the following phase change storage chip.

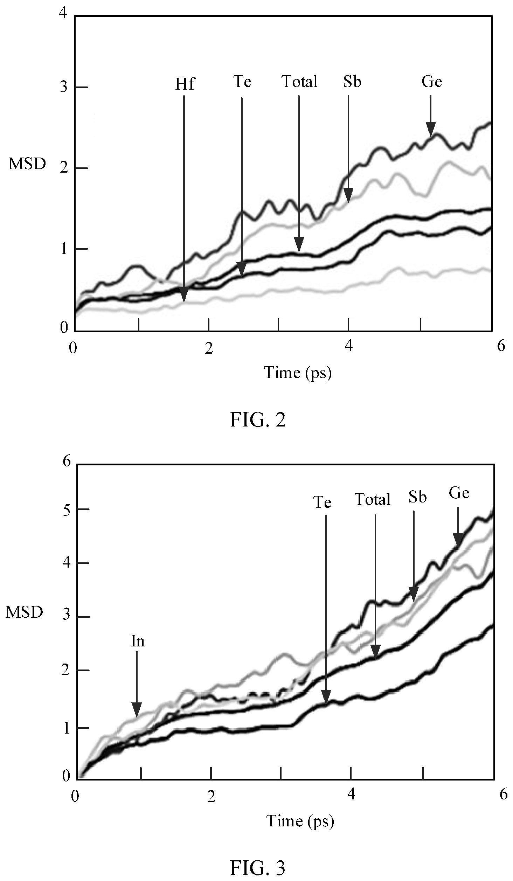

In this embodiment of this disclosure, mean square displacement of the element Hf, the element In, and the element Ga in the Ge-Sb-Te phase change base material is calculated according to a first principle. As shown in FIG. 2 to FIG. 4, mean square displacement of the element In and the element Ga in the Ge-Sb-Te phase change base material system is large. This indicates that under an ambient temperature condition, the element In and the element Ga are more likely to spread, to help the element In and the element Ga form an alloy with the metal element in another functional layer.

For example, when the another functional layer includes metal elements such as an element W, an element Ti, an element Ge, an element Ta, an element Hf, an element In, an element Ga, an element Al, an element Cu, an element Co, and an element Mo, the element In and the element Ga are likely to be combined with the metal elements to form an alloy, to form metal-metal bonds, to improve the adhesive force between the phase change material and the another functional layer, and increase the adhesive force of the phase change material layer.

In this embodiment of this disclosure, a related test is further performed on the adhesive force between a W electrode and phase change material layers corresponding to some phase change materials doped with the element In and not doped with the element In. Refer to Table 2. These phase change materials are respectively: (a) phase change material Hf-GeSbTe, which means that a Ge1Sb4Te6 phase change base material is doped with an element Hf alone, and an atomic percentage of Hf is 5%; (b) phase change material In-GeSbTe, which means that the Ge1Sb4Te6 phase change base material is doped with an element In alone, and an atomic percentage of In is 3%; and (c) phase change material InHf-GeSbTe, which means that the Ge1Sb4Te6 phase change base material is doped with both the element Hf and the element In, and atomic percentages of Hf and In are respectively 3% and 2%.

**Table 2**

| Test object | Adhesive force (a.u.) |
|---|---|
| Hf-GeSbTe/W electrode | 1 |
| InHf-GeSbTe/W electrode | 1.32 |
| In-GeSbTe/W electrode | 1.2 |

It can be learned from Table 2 that, based on that the atomic percentage of the element In meets a defined range of 1% to 5%, in comparison with an Hf-GeSbTe phase change material layer doped with Hf alone and an In-GeSbTe phase change material layer doped with In alone, there is a higher adhesive force between an InHf-GeSbTe phase change material layer doped with both the element Hf and the element In and the W electrode, so that the interface adhesive force is improved, and the adhesive force of the phase change material layer is increased.

It is further found through research that when the element In or the element Ga and the element Hf are both doped into the GeSbTe phase change base material, it can also ensure that the phase change component has a long life characteristic. To support the conclusion, in this embodiment of this disclosure, bonding strength of the element Hf, the element In, and the element Ga with the element Ge, the element Sb, and the element Te, and self-bonding strength of the element Hf, the element In, and the element Ga are further tested. A unit of the bonding strength is kJ/mol. For test results, refer to Table 3.

**Table 3**

| Object | Bonding strength with -Ge | Bonding strength with -Sb | Bonding strength with -Te | Self-bonding strength |
|---|---|---|---|---|
| Hf | 2.0 | 2.0 | 2.5 | 0.9 |
| In | 2.8 | 1.8 | 2.4 | 2.3 |
| Ga | 3.7 | 3.6 | 3.5 | 3.9 |

As shown in Table 3, the element Hf, the element In, and the element Ga can form covalent bonds with the element Hf, the element In, and the element Ga, and the element Hf, the element In, and the element Ga can form covalent bonds with the Ge element, the Sb element, and the Te element respectively, and the covalent bonds have similar strength. Therefore, if the element In or the element Ga is separately doped into the Ge-Sb-Te phase change base material, the element In or the element Ga and the Ge-Sb-Te phase change base material are likely to form a solid solution. After an electrical operation, element segregation of the element Ge, the element Sb, and the element Te cannot be prevented, resulting in a short life of the phase change component. However, in the phase change material provided in this embodiment of this disclosure, when the element In and/or the element Ga are/is introduced to the Ge-Sb-Te phase change base material, the element Hf is further introduced. A formed HfIn alloy and a formed HfGa alloy each have a high melting point, the HfIn alloy or the HfGa alloy can be stably retained in a melting procedure of RESET (about 600°C) of the phase change material, and stable HfIn and HfGa alloy clusters also hinder element segregation and phase separation of the Ge-Sb-Te phase change base material, which are both conducive to making the phase change component have a long life characteristic. Certainly, as described above, when another functional layer neighboring to the phase change material layer includes the element Hf, the HfIn alloy or the HfGa alloy is also extremely advantageous for enhancing the adhesive force of the phase change material layer.

In conclusion, according to the phase change material provided in this embodiment of this disclosure, at least one of the element N, the element C, the element In, and the element Ga is further doped into the Ge-Sb-Te phase change base material doped with the element Hf, so that the adhesive force of the phase change material layer can be enhanced, the phase change material layer is closely combined with another neighboring functional layer, an interface delamination probability is reduced, and a product yield of the phase change storage chip is increased, to avoid pollution and interference to the production line and production equipment. Particularly, a doping amount of the element Hf is 1.5% to 6.5%, and a doping amount of at least one of the element N, the element C, the element In, and the element Ga is 1.0% to 5.0%. This improves the adhesive force of the phase change material layer, and also helps enable the phase change component to have a large read window and a long life.

In some implementations, the phase change material provided in this embodiment of this disclosure further includes a third doping element, and the third doping element includes at least one of an element O, an element Si, an element B, an element Sn, an element Bi, an element Cd, an element Pb, an element Zr, an element Zn, an element Cr, an element Al, an element Sc, an element Y, an element Ta, an element Ti, an element Er, an element Lu, an element Ho, an element Tm, an element Dy, an element Tb, an element Ca, an element Nd, an element Pr, an element Yb, an element Ca, and an element Ce. An objective of optimizing comprehensive performance of the phase change storage component can also be achieved by further introducing a third doping element of a specific content into the phase change material. An atomic percentage of the third doping element in the phase change material is 0.01% to 10%.

For the Ge-Sb-Te phase change base material, a chemical formula of a Ge-Sb-Te compound may be any one of the following chemical formulas.

Chemical formula 1 is (GeTe₁₋ₐ)ₓ(Sb₂Te_{3-b})₁₋ₓ, where x is the atomic percentage and 0<x<1, a and b are parameters related to an atomic quantity ratio, 0<a≤1, 0<b≤3, and a=1 and b=3 do not coexist. For example, a compound GeTe₁₋ₐ means that a ratio of an atomic quantity of the element Ge to an atomic quantity of the element Te is 1:1-a, and Sb₂Te_{3-b} means that a ratio of an atomic quantity of the element Sb to an atomic quantity of the element Te is 2: 3-b. Certainly, it is not excluded that, in the compound GeTe₁₋ₐ, an atomic quantity of the element Ge and an atomic quantity of the element Te are respectively 1 and 1-a, and in the compound Sb₂Te_{3-b}, an atomic quantity of the element Sb and an atomic quantity of the element Te are respectively 2 and 3-b.

Chemical formula 2 is (GeTe_{1-c})ₓ(Sb_{y}Te_{1-d})₁₋ₓ, where x is an atomic percentage and 0<x<1, y, c, and d are parameters related to an atomic quantity ratio, y≥2, 0<c≤1, 0<d≤1, and c=1 and d=1 do not coexist. For example, a compound GeTe_{1-c} means that a ratio of an atomic quantity of the element Ge to an atomic quantity of the element Te is 1:1-c, and Sb_{y}Te_{1-d} means that a ratio of an atomic quantity of the element Sb to an atomic quantity of the element Te is y:1-d. Certainly, it is not excluded that, in the compound GeTe_{1-c}, an atomic quantity of the element Ge and an atomic quantity of the element Te are respectively 1 and 1-c, and in the compound Sb_{y}Te_{1-d}, an atomic quantity of the element Sb and an atomic quantity of the element Te are respectively y and 1-d.

For example, a value of a includes but is not limited to 0.1, 0.15, 0.2, 0.25, 0.3, 0.35, 0.4, 0.45, 0.5, 0.55, 0.6, 0.65, 0.7, 0.75, 0.8, 0.85, 0.9, 0.95, 1, and the like.

A value of b includes but is not limited to: 0.1, 0.2, 0.3, 0.4, 0.5, 0.6, 0.7, 0.8, 0.9, 1, 1.1, 1.2, 1.3, 1.4, 1.5, 1.6, 1.7, 1.8, 1.9, 2, 2.1, 2.2, 2.3, 2.4, 2.5, 2.6, 2.7, 2.8, 2.9, 3, and the like.

A value of y includes but is not limited to 2, 2.1, 2.2, 2.3, 2.4, 2.5, 2.6, 2.7, 2.8, 2.9, 3, 3.1, 3.2, 3.3, 3.4, 3.5, 3.6, 3.7, 3.8, 3.9, 4, 4.1, 4.2, 4.3, 4.4, 4.5, 4.6, 4.7, 4.8, 4.9, 5, 6, 7, 8, 9, 10, and the like.

A value of c includes but is not limited to: 0.1, 0.15, 0.2, 0.25, 0.3, 0.35, 0.4, 0.45, 0.5, 0.55, 0.6, 0.65, 0.7, 0.75, 0.8, 0.85, 0.9, 0.95, 1, and the like.

A value of d includes but is not limited to: 0.1, 0.15, 0.2, 0.25, 0.3, 0.35, 0.4, 0.45, 0.5, 0.55, 0.6, 0.65, 0.7, 0.75, 0.8, 0.85, 0.9, 0.95, 1, and the like.

In this embodiment of this disclosure, the chemical formula of the Ge-Sb-Te phase change base material is described above, to ensure that the phase change material layer obtained based on the Ge-Sb-Te phase change base material in this embodiment of this disclosure has a stronger adhesive force than a phase change material layer obtained based on another Ge-Sb-Te phase change base material. This is because GeTe, Sb₂Te₃ and Sb_{y}Te(y≥2) are all stable compounds with a stable chemical composition ratio. Considering that a single element material of Te is a typical two-dimensional material, a layered structure is formed through Te-Te bonding, the layers are bonded by a Van der Wafer force, and an adhesive force is poor. In addition, a melting point (620°C) of Sb₂Te₃ is higher than a melting point (450°C) of the single element material of Te. At a high temperature in a phase change procedure, Te is more likely to precipitate to form a two-dimensional material of the single element material of Te, resulting in a poor adhesive force. In this embodiment of this disclosure, a, b, c, and d are all greater than 0, so that the Ge-Sb-Te phase change base material is in a lack-Te state compared with the foregoing stable compounds. By properly reducing content of the element Te, it is ensured that the adhesive force of the phase change material layer is stronger than that of the phase change material layer corresponding to the Ge-Sb-Te phase change base material.

To support the foregoing conclusion, a related adhesive force test is performed in this embodiment of this disclosure. A test result is that an adhesive force between a Ge-Sb-Te phase change base material lacking Te and the W electrode is 1.14 a.u., and an adhesive force between a Ge-Sb-Te phase change base material not lacking Te and the W electrode is 1 a.u.. It can be learned that the Ge-Sb-Te phase change base material lacking Te has a stronger adhesive force than the Ge-Sb-Te phase change base material not lacking Te.

In some examples, a chemical formula 1 of the Ge-Sb-Te phase change base material is (GeTe₁₋ₐ)ₓ(Sb₂Te_{3-b})₁₋ₓ, where 0.2<x≤0.4; and a chemical formula 2 of the Ge-Sb-Te phase change base material is (GeTe_{1-c})ₓ(Sb_{y}Te_{1-d})₁₋ₓ, where 0.2<x≤0.4.

For example, a value of x includes but is not limited to 0.22, 0.23, 0.24, 0.25, 0.26, 0.27, 0.28, 0.29, 0.3, 0.31, 0.32, 0.33, 0.34, 0.35, 0.36, 0.37, 0.38, 0.39, 0.4, and the like.

The chemical formula of the Ge-Sb-Te phase change base material is shown above, so that on a basis of ensuring that the adhesive force of the phase change material layer is strong enough, a delay of the phase change component is accelerated, and a life of the phase change component is prolonged.

An existence form of the foregoing phase change material provided in this embodiment of this disclosure includes but is not limited to the following: an alloy form, a compound form, a phase combination form of a single element material and a compound, a phase combination form of a single element material and an alloy, and the like. The phase change material layer is prepared based on the foregoing various forms of phase change materials.

For example, an existence form of the phase change material is a Ge-Sb-Te ternary compound/alloy, a single element material or a compound corresponding to an element Hf, and a phase combination of a single element material and a compound corresponding to at least one of an element N, an element C, an element In, and an element Ga. In this case, a corresponding quantity of the foregoing single element materials or compounds is provided based on the atomic percentage of each element in the phase change material and a ratio. The Ge-Sb-Te ternary compound/alloy, the single element material or the compound corresponding to the element Hf, and the combination of the single element material and the compound corresponding to at least one of the element N, the element C, the element In, and the element Ga may not need to be mixed, so that the three types of materials are independent of each other for backup. Alternatively, the three types of materials may be mixed, and form a phase change material in a form of a compound or an alloy in a melting manner.

Certainly, it is not excluded that the phase change material may further exist in the following form: a single element material of the element Ge, a single element material of the element Sb, a single element material of the element Te, a single element material of the element Hf, and a phase combination form of a single element material corresponding to at least one of the element N, the element C, the element In, and the element Ga. Corresponding quantities of single element materials are provided based on the atomic percentage of each element in the phase change material and the ratio. These specific quantities of single element materials do not need to be mixed and may be independent of each other. Alternatively, these specific quantities of single element materials may be mixed, and form a phase change material in a form of a compound or an alloy in a melting manner.

A second embodiment of this disclosure further provides a phase change material. The phase change material includes a Ge-Sb-Te phase change base material and a first doping element and a second doping element that are doped into the Ge-Sb-Te phase change base material. The first doping element includes an element Hf, and an atomic percentage of the first doping element in the phase change material is 1.5% to 7%. The second doping element includes at least one of an element N, an element C, an element In, and an element Ga, and an atomic percentage of the second doping element in the phase change material is 1.0% to 7%. In addition, a sum of the atomic percentage of the first doping element and the atomic percentage of the second doping element is greater than 4% and less than 10%.

For example, some examples of the atomic percentage of the first doping element Hf in the phase change material include but are not limited to 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, and the like.

For example, some examples of the atomic percentage of the second doping element in the phase change material include but are not limited to 1%, 1.1%, 1.2%, 1.3%, 1.4%, 1.5%, 1.6%, 1.7%, 1.8%, 1.9%, 2%, 2.1%, 2.2%, 2.3%, 2.4%, 2.5%, 2.6%, 2.7%, 2.8%, 2.9%, 3%, 3.1%, 3.2%, 3.3%, 3.4%, 3.5%, 3.6%, 3.7%, 3.8%, 3.9%, 4%, 4.1%, 4.2%, 4.3%, 4.4%, 4.5%, 4.6%, 4.7%, 4.8%, 4.9%, 5%, 5.1%, 5.2%, 5.3%, 5.4%, 5.5%, 5.6%, 5.7%, 5.8%, 5.9%, 6%, 6.1%, 6.2%, 6.3%, 6.4%, 6.5%, 6.6%, 6.7%, 6.8%, 6.9%, and the like.

A sum of the atomic percentage of the first doping element and the atomic percentage of the second doping element may be 4.5%, 5%, 5.5%, 6%, 6.5%, 7%, 7.5%, 8%, 8.5%, 9%, 9.5%, or the like.

The second doping element may be one of the element N, the element C, the element In, and the element Ga. For example, the second doping element is the element N, the element C, the element In, or the element Ga, or the second doping element may be a combination of any two or any three of the element N, the element C, the element In, and the element Ga, or include all of the four elements.

For a related principle of enhancing an adhesive force of a phase change material layer when the second doping element is the element N, the element C, the element In, or the element Ga, refer to the related principle descriptions in the phase change material in the foregoing first embodiment. Details are not described herein again.

In comparison with the phase change material in the first embodiment, atomic percentage content of the element N, the element C, the element In, or the element Ga in the phase change material in the second embodiment increases (the atomic percentage is 1.0% to 7%).

In this type of phase change material layer, doping concentration of the first doping element and doping concentration of the second doping element need to be controlled within 7% or less. In addition to ensuring that the phase change material layer has a strong adhesive force, it is also ensured that a phase change component has high and stable high resistance, to increase a read window, improve cycle stability of the phase change component, and it is ensured that the phase change component has high and stable low resistance, to prolong a life and improve cycle stability of the phase change component. Reasons are as follows.

It is found through research that when the atomic percentage of the first doping element and the atomic percentage of the second doping element are separately greater than 7%, a side effect is generated, and performance such as a read window and a life of the phase change component deteriorates.

An example in which the second doping element is the element N. It can be learned from data in Table 5 in Embodiment 5 that, when the atomic percentage of the element Hf is excessively high (greater than 7%), the high resistance of the phase change component decreases, resulting in a narrowed read window. In addition, the high resistance is unstable in a cycle procedure, and segregation is likely to occur. Consequently, the phase change component is likely to fail due to fatigue. When the atomic percentage of the element N is excessively high (greater than 7%), the low resistance of the phase change component increases abnormally, is unstable in a cycle procedure, and keeps decreasing in a fatigue procedure. This may be related to segregation caused by thermoelectric accumulation that is more likely to occur in an operation procedure.

As shown in Table 5, when the atomic percentage of the element Hf is 8% (exceeding a defined upper limit 7%), the high resistance of the phase change storage chip becomes low and is unstable in a cycle. When the atomic percentage of the element N is 8% (exceeding a defined upper limit 7%), the low resistance of the phase change storage chip is unstable in the cycle although the low resistance becomes higher. Therefore, in this embodiment of this disclosure, when the atomic percentage of the element Hf and the atomic percentage of the element N are separately less than or equal to 7%, it is ensured that the phase change component has high and stable high resistance, and it is ensured that the phase change component has high and stable low resistance.

In addition, in this type of phase change material, the sum of the atomic percentage of the first doping element and the atomic percentage of the second doping element further needs to be greater than 4% and less than 10%. In this way, it is ensured that the phase change material layer has a strong adhesive force, and the phase change component can also have a long life and cycle stability. Reasons are as follows.

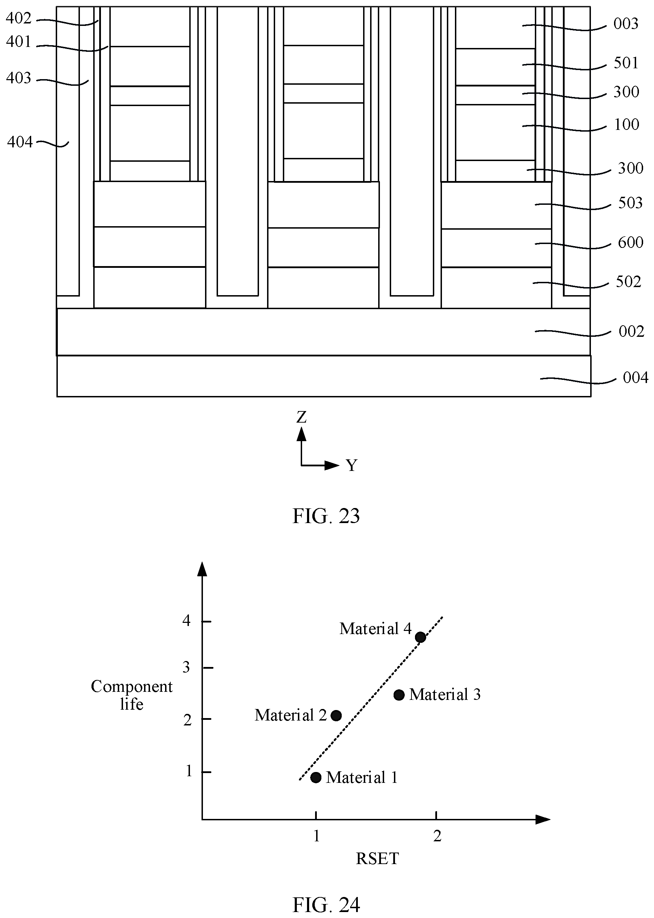

It is found through research that, for this type of phase change material, a life of the phase change component is related to the doping concentration of Hf and the doping concentration of the second doping element. In performance analysis of the phase change component, it is found that the low resistance of the phase change component is in direct proportion to a final fatigue life of the phase change component. As shown in FIG. 24, within a specific range, higher low resistance of the phase change component indicates a better fatigue characteristic of the phase change component. The low resistance of the phase change component is mainly determined by low resistance and a crystallization temperature of the phase change material layer. Values of a horizontal coordinate and a vertical coordinate in FIG. 24 are both obtained by using normalized logarithms.

An example in which the second doping element is the element N. It can be learned from data in Table 1 that, when the doping concentration of the element Hf and the doping concentration of the element N increase, both the low resistance and the crystallization temperature of the phase change material layer are correspondingly increased (refer to the phase change material 3 and the phase change material 4 in Table 1). Therefore, the low resistance of the phase change component is also increased, and the phase change component obtains a longer life.

Therefore, to ensure a longer life of the phase change component, the low resistance of the phase change material layer needs to be as high as possible on a premise of maintaining a specific read window. However, in the phase change material 4 in Table 1, an atomic percentage of an element Hf in the phase change material 4 is 2% and an atomic percentage of an element N in the phase change material 4 is 2%, and in the phase change material 1 in Table 1, an atomic percentage of an element Hf in the phase change material 1 is 4% and an atomic percentage of an element N in the phase change material 1 is 0%. Low resistive state resistance of phase change material layers corresponding to the two phase change materials is both about 400 ohms, which is far less than 1 k ohms, and sums of the atomic percentage of the element Hf and the atomic percentage of the element N in the two phase change materials are both 4%. Therefore, in this embodiment of this disclosure, the sum of the atomic percentage of the element Hf and the atomic percentage of the element N is limited to be greater than 4%, in other words, the sum of the atomic percentage of the first doping element and the atomic percentage of the second doping element is greater than 4%. This is very necessary to grant a long life characteristic to the phase change component.

A higher sum of the doping concentration of the first doping element and the doping concentration of the second doping element is not better. It is confirmed through research that when the sum of the doping concentration of the first doping element and the doping concentration of the second doping element is greater than 10%, a side effect is generated, and in a cycle procedure of the phase change component is unstable. This includes: The low resistance of the phase change component increases abnormally and is unstable in the cycle procedure. Specifically, resistance continuously decreases in the cycle procedure, which may be caused by segregation caused by thermoelectric accumulation that is more likely to occur in the phase change material layer in an operation procedure. The example in which the second doping element is the element N is still used. It can be learned from the data in Table 5 in Embodiment 5 that, when the atomic percentage of the element Hf is 6.5% and the atomic percentage of the element N is 5%, because the sum of the atomic percentages of the two elements is greater than 10%, the low resistance increases abnormally and is unstable in the cycle procedure, it is expected that the sum of the atomic percentage of the element Hf and the atomic percentage of the element N is less than 10%.

In conclusion, according to this type of phase change material provided in this embodiment of this disclosure, at least one of the element N, the element C, the element In, and the element Ga is further doped into the Ge-Sb-Te phase change base material doped with the element Hf, so that the adhesive force of the phase change material layer can be enhanced, the phase change material layer is closely combined with another neighboring functional layer, an interface delamination probability is reduced, and a product yield of the phase change storage chip is increased, to avoid pollution and interference to the production line and production equipment. Particularly, a doping amount of the element Hf is 1.5% to 7%, a doping amount of at least one of the element N, the element C, the element In, and the element Ga is 1.0% to 7%, and the sum of the atomic percentages of the two doping elements is greater than 4% and less than 10%. This improves the adhesive force of the phase change material layer, and also helps enable the phase change component to have a large read window, a long life, and cycle stability.

In some implementations, the phase change material provided in this embodiment of this disclosure further includes a third doping element, and the third doping element includes at least one of an element O, an element Si, an element B, an element Sn, an element Bi, an element Cd, an element Pb, an element Zr, an element Zn, an element Cr, an element Al, an element Sc, an element Y, an element Ta, an element Ti, an element Er, an element Lu, an element Ho, an element Tm, an element Dy, an element Tb, an element Ca, an element Nd, an element Pr, an element Yb, an element Ca, and an element Ce. An objective of optimizing comprehensive performance of the phase change storage component can also be achieved by further introducing a third doping element of a specific content into the phase change material. An atomic percentage of the third doping element in the phase change material is 0.01% to 10%.

For the Ge-Sb-Te phase change base material, a chemical formula of a Ge-Sb-Te compound may be any one of the following chemical formulas.

Chemical formula 1 is (GeTe₁₋ₐ)ₓ(Sb₂Te_{3-b})₁₋ₓ, where x is the atomic percentage and 0<x<1, a and b are parameters related to an atomic quantity ratio, 0<a≤1, 0<b≤3, and a=1 and b=3 do not coexist.

Chemical formula 2 is (GeTe_{1-c})ₓ(Sb_{y}Te_{1-d})₁₋ₓ, where x is an atomic percentage and 0<x<1, y, c, and d are parameters related to an atomic quantity ratio, y≥2, 0<c≤1, 0<d≤1, and c=1 and d=1 do not coexist.

For example values and related explanations of the parameters in the chemical formula 1 and the chemical formula 2 of the Ge-Sb-Te phase change base material, refer to related descriptions in the phase change material in the first embodiment. Details are not described herein again.

In this embodiment of this disclosure, the chemical formula of the Ge-Sb-Te phase change base material is described above, to ensure that the phase change material layer obtained based on the Ge-Sb-Te phase change base material in this embodiment of this disclosure has a stronger adhesive force than a phase change material layer obtained based on another Ge-Sb-Te phase change base material. This is because GeTe, Sb₂Te₃ and Sb_{y}Te(y≥2) are all stable compounds with a stable chemical composition ratio. Considering that a single element material of Te is a typical two-dimensional material, a layered structure is formed through Te-Te bonding, the layers are bonded by a Van der Wafer force, and an adhesive force is poor. In addition, a melting point (620°C) of Sb₂Te₃ is higher than a melting point (450°C) of the single element material of Te. At a high temperature in a phase change procedure, Te is more likely to precipitate to form a two-dimensional material of the single element material of Te, resulting in a poor adhesive force. In this embodiment of this disclosure, a, b, c, and d are all greater than 0, so that the Ge-Sb-Te phase change base material is in a lack-Te state compared with the foregoing stable compounds. By properly reducing content of the element Te, it is ensured that the adhesive force of the phase change material layer is strong enough.

In addition, for a related adhesive force test on the Ge-Sb-Te phase change base material, reference may still be made to related descriptions in the phase change material in the first embodiment. Details are not described herein again.

In some examples, a chemical formula 1 of the Ge-Sb-Te phase change base material is (GeTe₁₋ₐ)ₓ(Sb₂Te_{3-b})₁₋ₓ, where 0.2<x≤0.4; and a chemical formula 2 of the Ge-Sb-Te phase change base material is (GeTe_{1-c})ₓ(Sb_{y}Te_{1-d})₁₋ₓ, where 0.2<x≤0.4.

For example, a value of x includes but is not limited to 0.22, 0.23, 0.24, 0.25, 0.26, 0.27, 0.28, 0.29, 0.3, 0.31, 0.32, 0.33, 0.34, 0.35, 0.36, 0.37, 0.38, 0.39, 0.4, and the like.

When 0.2<x≤0.4, the corresponding chemical formula 1 or chemical formula 2 of the Ge-Sb-Te phase change base material may alternatively be expressed in another manner as follows: GeₓSb_{y}Te_{1-x-y}, where x and y both represent atomic percentages of corresponding elements, 6%<x<15%, and 35%<y<45% (or GeₓSb_{y}Te_{100-x-y}, where x and y are both mass quantities of corresponding atoms, 6<x<15, and 35<y<45).

For example, on the basis that the foregoing chemical formula is met, in the Ge-Sb-Te phase change base material, a ratio between atomic percentage content of the element Ge, the element Sb, and the element Te includes but is not limited to: 1:4:5, 1:4:6, 1:4:7, and the like, and corresponding GeSbTe compounds are respectively referred to as GeSbTe145 (or GelSb4Te5 or GST145), GeSbTe146 (or Gel Sb4Te6 or GST146), and GeSbTe147 (or Gel Sb4Te7 or GST147).

The chemical formula of the Ge-Sb-Te phase change base material is shown above, so that this not only ensures that the adhesive force of the phase change material layer is strong enough, but also helps reduce a delay of the phase change component and prolong the life of the phase change component.

In this embodiment of this disclosure, a related test is performed on impact of content of the element Ge and the element Sb in the Ge-Sb-Te phase change base material on the adhesive force, the delay, and the life. A test result shows that an atomic percentage of the element Sb is an important factor that determines a speed of the phase change component. A crystallization temperature of a single element material of Sb is low and a growth speed is fast, so that the atomic percentage of the element Sb is positively correlated with SET performance of the phase change component. Theoretically, a higher atomic percentage of the element Sb indicates a lower delay of the phase change component.

It is proved through experiments that when the atomic percentage of Sb in the Ge-Sb-Te phase change base material is greater than 35% (correspondingly, x≤0.4 in the foregoing stoichiometric ratio is met), because the crystallization temperature of the single element material of Sb is low and the growth speed is fast, the delay of the phase change component can be less than 100 ns. However, a higher atomic percentage of Sb is not better. When atomic percentage content of Sb in the Ge-Sb-Te phase change base material exceeds 45% (correspondingly, x>0.2 in the foregoing stoichiometric ratio is met), because a quantity of stable compounds formed by bonding Sb and Te is relatively reduced, the single element material of Sb is relatively excessive and has poor stability, and consequently, the life of the phase change component is shortened to some extent. It can be learned that, the atomic percentage of Sb is limited to be greater than 35% and less than 45%, to help the phase change component have both a low delay and a long life.

For the element Ge, it is proved through experiments that when an atomic percentage of the element Ge is greater than 15%, and concentration of the element Ge is excessively high, the delay of the phase change component is slowed down to some extent; and when the atomic percentage of the element Ge is less than 6% (correspondingly, x>0.2 in the foregoing stoichiometric ratio is met), and the concentration of the element Ge is excessively low, the adhesive force of the phase change material layer is reduced, and consequently, it is excessively difficult to optimize a mass production process. It can be learned that, the atomic percentage of Ge is limited to be greater than 6% and less than 15%, to help ensure that the phase change material layer has a strong adhesive force and enable the phase change component to have a low delay.

In addition, for an existence form of the phase change material provided in the second embodiment, reference may still be made to related descriptions in the phase change material in the first embodiment. Details are not described herein again.

It can be learned that, in this embodiment of this disclosure, a corresponding coupling relationship between different elements in the phase change material and performance (a speed, a life, a window, and an adhesive force) of a key component is identified, and a stoichiometric ratio of each element is adjusted, to balance and optimize performance of the phase change storage chip, to ensure better comprehensive performance of the phase change storage chip.

An embodiment of this disclosure further provides a phase change storage chip. The phase change storage chip includes a plurality of phase change storage units, the phase change storage unit includes a phase change material layer 100, and the phase change material layer 100 is prepared by using any one of the foregoing phase change materials.

The phase change storage chip may also be referred to as a phase change memory. The phase change storage chip provided in this embodiment of this disclosure is prepared based on the phase change material layer 100 of the phase change storage chip by the phase change material provided in this embodiment of this disclosure, so that the phase change storage chip has all advantages of the phase change material provided in this embodiment of this disclosure.

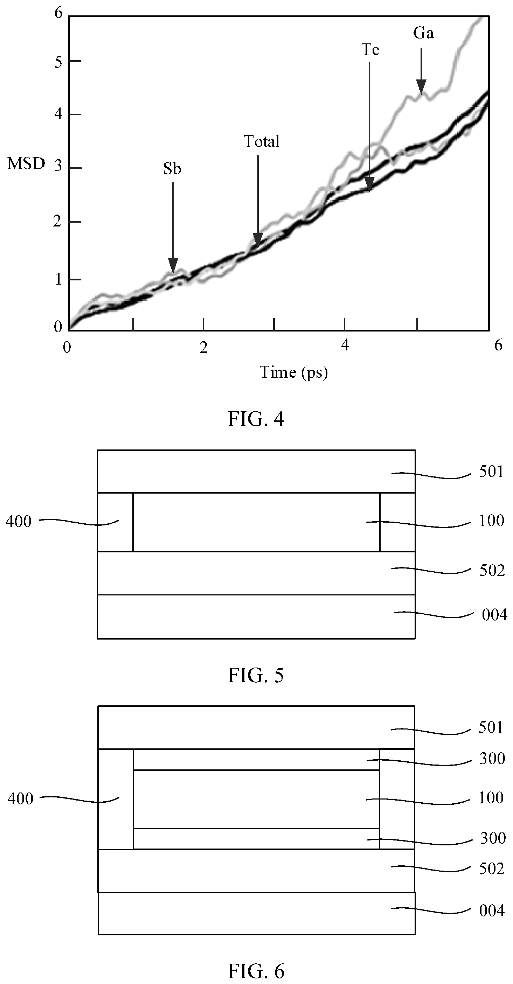

The phase change storage unit is arranged on a substrate 004. In some examples, as shown in FIG. 5, in addition to the phase change material layer 100, the phase change storage unit further includes a top electrode 501, a bottom electrode 502, and an insulation layer 400. In a bottom-up direction, the substrate 004, the bottom electrode 502, the phase change material layer 100, and the top electrode 501 are sequentially arranged in a stacked manner, and the insulation layer 400 wraps an outer side of at least the phase change material layer 100.

In some other examples, in addition to the foregoing phase change material layer 100, as shown in FIG. 6, the phase change storage unit further includes a top electrode 501, a bottom electrode 502, an insulation layer 400, and a barrier layer 300. In a bottom-up direction, the substrate 004, the bottom electrode 502, the barrier layer 300, the phase change material layer 100, the barrier layer 300, and the top electrode 501 are sequentially arranged in a stacked manner, and the insulation layer 400 wraps an outer side of at least the phase change material layer 100 and the barrier layer 300.

For example, a barrier layer material used by the barrier layer 300 includes at least one of single element materials of an element W, an element Ti, an element Ge, an element Ta, an element Hf, an element In, an element Ga, an element Al, an element Cu, an element Co, and an element Mo, nitrides of the foregoing elements, and carbides of the foregoing elements.

An example in which a second doping element in the phase change material layer 100 is an element N or an element C is used. The element N or the element C can be bonded with the foregoing metal element in the barrier layer 300, to form non-metal-metal ion bonds, to improve a bonding force between an adhesive layer 200 and the barrier layer 300, and reduce a probability of interface delamination between the adhesive layer 200 and the barrier layer 300 in a processing procedure.

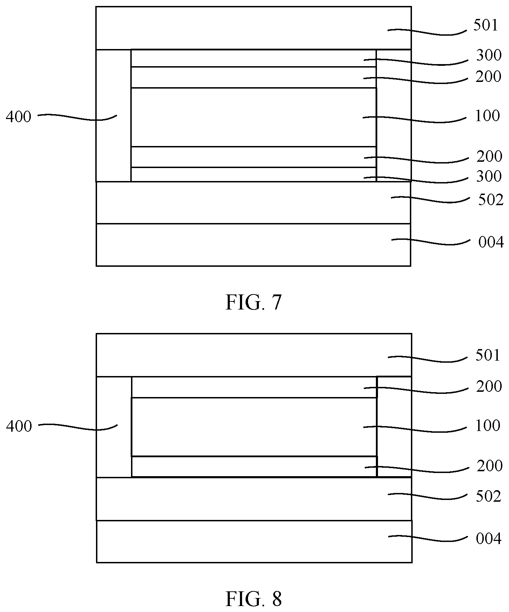

Further, as shown in FIG. 7 and FIG. 8, the phase change storage unit provided in this embodiment of this disclosure further includes the adhesive layer 200. The adhesive layer 200 is arranged on at least one surface of the phase change material layer 100 in a stacked manner, and the adhesive layer 200 is configured to increase an adhesive force between the phase change material layer 100 and a neighboring functional layer.

For example, the adhesive layer 200 may be arranged on a surface that is of the phase change material layer 100 and that faces the top electrode 501, or the adhesive layer 200 may be arranged on a surface that is of the phase change material layer 100 and that faces the bottom electrode 502, or the adhesive layer 200 may be separately arranged on the foregoing two opposite surfaces of the phase change material layer 100.

The adhesive layer 200 is added to at least one surface of the phase change material layer 100, to increase the adhesive force between the phase change material layer 100 and the neighboring functional layer. The neighboring functional layer may be the barrier layer 300, or may be the electrode layer.

It can be learned that, in the phase change storage chip provided in this embodiment of this disclosure, not only the phase change material is improved, but also a structure of the phase change storage chip is improved to add the adhesive layer 200 to the phase change storage chip, to further improve the adhesive force between the phase change material layer 100 and the neighboring functional layer, significantly reduce an interface delamination probability, increase a product yield of the phase change storage unit, and avoid pollution, interference, and the like to a production line.

The adhesive layer 200 is prepared by using an adhesive layer raw material. In some implementations, the adhesive layer raw material includes at least one of a nitride of a target element and a carbide of the target element. The target element is selected from at least one of an element W, an element Ti, an element Ge, an element Ta, an element Hf, an element In, an element Ga, an element Al, an element Cu, an element Co, and an element Mo. An example in which the target element is the element W is used. The adhesive layer raw material may be tungsten nitride, or may be tungsten carbide.

When the second doping element in the phase change material layer 100 is the element N or the element C, the element N or the element C and the target element in the adhesive layer 200 can form non-metal-metal ion bonds, to improve a bonding force between the adhesive layer 200 and the phase change material layer 100, enhance the interface adhesive force, and reduce a probability of interface delamination between the adhesive layer 200 and the phase change material layer 100 in a processing procedure.

When the second doping element in the phase change material layer 100 is the element In or the element Ga, the element In or the element Ga can be combined with the target element in the adhesive layer 200 to form an alloy, and form metal-metal bonds, to improve a bonding force between the adhesive layer 200 and the phase change material layer 100, enhance the interface adhesive force, and reduce a probability of interface delamination between the adhesive layer 200 and the phase change material layer 100 in a processing procedure.

It can be learned that, by using the foregoing adhesive layer raw material, an interface bonding capability and a bonding force between the phase change material layer and the adhesive layer can be enhanced, to prevent a decreased component yield caused by the phase change material layer falling off from an interface of the barrier layer.

To prove that the interface adhesive force in the phase change storage chip having the adhesive layer is stronger, this embodiment of this disclosure provides the following plurality of types of phase change materials for related adhesive force test experiments. These phase change materials are respectively shown as follows: (d) phase change material HfGST, which means that a GelSb4Te6 phase change base material is doped with an element Hf alone, and an atomic percentage of Hf is 3%; and (e) phase change material NHfGST, which means that the Ge1Sb4Te6 phase change base material is doped with both the element Hf and the element N, and an atomic percentage of Hf and an atomic percentage of N are respectively 3% and 2%. Adhesive forces between a W electrode and phase change material layers corresponding to the phase change materials are tested. For test results, refer to Table 2.

Adhesive forces between the W electrode and the phase change material layers corresponding to the phase change materia and adhesive forces between an adhesive layer of a W₂N material and the phase change material layers corresponding to the phase change materials are separately tested. For test results, refer to Table 4.

**Table 4**

| Test object | Adhesive force extreme value (N) | Adhesive force mid value (N) |
|---|---|---|
| NHfGST/W electrode | 2118 | 1408 |
| HfGST/W electrode | 1847 | 1272 |
| NHfGST/Adhesive layer W₂N | 2234 | 1435 |

It can be learned from Table 4 that, on a basis that the atomic percentage of the element Hf and the atomic percentage of the element N meet respective limited atomic percentage ranges, it can be learned that, in comparison with a phase change material layer doped with the element Hf alone, in this application, an adhesive force between the phase change material layer doped with both the element Hf and the element N and the W electrode is significantly greater than an adhesive force between the phase change material layer not doped with the element N and the W electrode, and the adhesive force between the phase change material layer doped with both the element Hf and the element N and the W electrode is slightly less than an adhesive force between the phase change material layer doped with both the element Hf and the element N and the adhesive layer W₂N. It can be learned that, the interface adhesive force of the phase change material layer can be further improved by further adding adhesive layers.

In some other implementations, the adhesive layer raw material includes a Ge-Sb-Te phase change material doped with a fourth doping element, and the adhesive layer raw material is different from a phase change material used by the phase change material layer. The fourth doping element is selected from at least one of an element Hf, an element N, an element C, an element In, and an element Ga, and an atomic percentage of the fourth doping element in the adhesive layer raw material is 0.01% to 20%, and may further be 0.01% to 10%.

A chemical formula of the related Ge-Sb-Te phase change material may be shown as follows: (GeTe₁₋ₐ)ₓ(Sb₂Te_{3-b})₁₋ₓ, where 0<x<1, 0<a≤1, 0<b≤3, and a=1 and b=3 do not coexist (x, a, and b herein are all some parameters indicating the atomic percentage). Alternatively, a chemical formula of the Ge-Sb-Te phase change material may be shown as follows: (GeTe_{1-c})ₓ(Sb_{y}Te_{1-d})₁₋ₓ, where 0<x<1, y≥2, 0<c≤1, 0<d≤1, and c=1 and d=1 do not coexist (x, y, c, and d herein are all some parameters indicating the atomic percentage).

For example, simplified formulas of some applicable adhesive layer raw materials may be shown as follows: NHfGeSbTe, CHfGeSbTe, InHfGeSbTe, GaHfGeSbTe, HfGeSbTe, NGeSbTe, CGeSbTe, InGeSbTe, GaGeSbTe, and the like.

A doping amount of the fourth doping element in the Ge-Sb-Te phase change material is within the foregoing range, so that the Ge-Sb-Te phase change material doped with the fourth doping element is different from the phase change material in the phase change material layer 100, and mainly performs an interface adhesive function.

As described above, the adhesive layer 200 is located between the phase change material layer 100 and the neighboring functional layer. The neighboring functional layer may be the barrier layer 300, or may be the electrode layer (including at least one of the top electrode 501 and the bottom electrode 502).

In a solution, the phase change storage unit includes the barrier layer 300, and the adhesive layer 200 is located between the phase change material layer 100 and the barrier layer 300 and is configured to increase the adhesive force between the phase change material layer 100 and the barrier layer 300.

In the phase change storage unit, the barrier layer 300 has a function of preventing an element in the phase change material layer 100 from spreading to the electrode layer. The adhesive layer 200 is located between the phase change material layer 100 and the barrier layer 300, to effectively prevent delamination between the phase change material layer 100 and the barrier layer 300.

In some examples, as shown in FIG. 7, there are two barrier layers 300, and the two barrier layers 300 are respectively located on two opposite sides of the phase change material layer 100. In this case, there may also be two adhesive layers 200. One adhesive layer 200 is located between a first surface of the phase change material layer 100 and one barrier layer 300, and the other adhesive layer 200 is located between a second surface of the phase change material layer 100 and the other barrier layer 300.

For example, a barrier layer material used by the barrier layer 300 includes at least one of single element materials of an element W, an element Ti, an element Ge, an element Ta, an element Hf, an element In, an element Ga, an element Al, an element Cu, an element Co, and an element Mo, nitrides of the foregoing elements, and carbides of the foregoing elements. Certainly, the barrier layer material is different from the adhesive layer material.

When the second doping element in the phase change material layer 100 is the element N or the element C, the element N or the element C and the metal element in the barrier layer 300 can form non-metal-metal ion bonds, to improve a bonding force between the barrier layer 300 and the phase change material layer 100, enhance the interface adhesive force, and reduce a probability of interface delamination between the barrier layer 300 and the phase change material layer 100 in a processing procedure.

When the second doping element in the phase change material layer 100 is the element In or the element Ga, the element In or the element Ga can be combined with the metal element in the barrier layer 300 to form an alloy, and form metal-metal bonds, to improve a bonding force between the barrier layer 300 and the phase change material layer 100, enhance the interface adhesive force, and reduce a probability of interface delamination between the barrier layer 300 and the phase change material layer 100 in a processing procedure.

For the foregoing solution, in addition to the foregoing phase change material layer 100, the adhesive layer 200, and the barrier layer 300, the phase change storage unit may further include the top electrode 501, the bottom electrode 502, and the insulation layer 400. In an example, as shown in FIG. 7, in a bottom-up direction, the substrate 004, the bottom electrode 502, the barrier layer 300, the adhesive layer 200, the phase change material layer 100, the adhesive layer 200, the barrier layer 300, and the top electrode 501 are sequentially arranged in a stacked manner, and the insulation layer 400 wraps an outer side of at least the phase change material layer 100, the adhesive layer 200, and the barrier layer 300.

In some examples, a thickness of the barrier layer 300 and a thickness of the adhesive layer 200 are separately 1 nm to 8 nm, which include but are not limited to 1 nm, 2 nm, 3 nm, 4 nm, 5 nm, 6 nm, 7 nm, 8 nm, and the like. For example, both the thickness of the barrier layer 300 and the thickness of the adhesive layer 200 may be 2 nm.

In another solution, the phase change storage unit includes an electrode layer, and the adhesive layer 200 is located between the phase change material layer 100 and the electrode layer and is configured to increase an adhesive force between the phase change material layer 100 and the electrode layer. The adhesive layer 200 is located between the phase change material layer 100 and the corresponding electrode layer, to effectively prevent delamination between the phase change material layer 100 and the electrode layer.

For the foregoing solution, in addition to the phase change material layer 100 and the adhesive layer 200, the phase change storage unit may further include the top electrode 501, the bottom electrode 502, and the insulation layer 400. In an example, as shown in FIG. 8, in a bottom-up direction, the substrate 004, the bottom electrode 502, the adhesive layer 200, the phase change material layer 100, the adhesive layer 200, and the top electrode 501 are sequentially arranged in a stacked manner, and the insulation layer 400 wraps an outer side of at least the phase change material layer 100 and the adhesive layer 200.

For the foregoing phase change storage unit, a structure of the phase change storage unit includes but is not limited to the following: a restrictive structure, a T-shaped structure, a U-shaped groove structure, an L-shaped structure, and the like.

In some implementations, the phase change storage chip provided in this embodiment of this disclosure further includes a plurality of selector units, and the selector units and the phase change storage units are arranged in series. The selector unit is used as a switch component of the phase change storage unit, to effectively suppress a leakage current generated in a working procedure of the phase change storage chip.

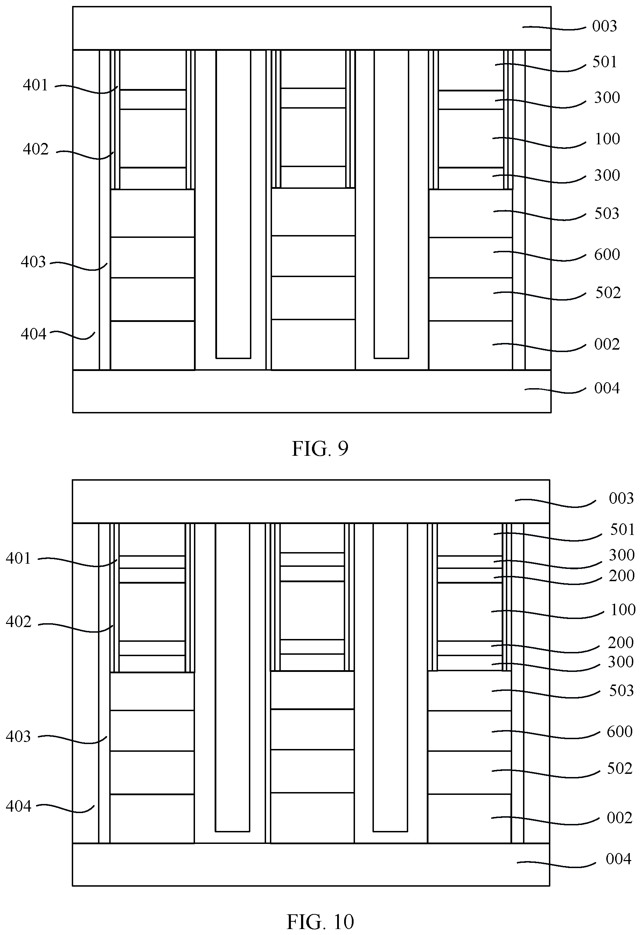

Refer to FIG. 9. The selector unit includes a selector layer 600, and a selector material used by the selector layer 600 includes at least one of an S-series selector material, an Se-series selector material, and a Te-series selector material. The foregoing S-series selector material, Se-series selector material, and Te-series selector material may all use some currently known or on-sale gating materials. Examples are not described herein one by one. The foregoing selector material may be a binary compound, a ternary compound, or another multi-element compound including more elements.

Further, the selector material further includes a fifth doping element, and the fifth doping element is selected from at least one of an element B, an element Al, an element Ga, an element In, an element C, an element Si, an element Ge, an element Sn, an element N, an element P, an element As, an element Sb, an element Bi, an element O, an element Au, an element Hf, an element Pd, an element Cu, an element Co, an element Ag, an element Pt, an element Sc, an element Ti, and an element Ta. An atomic percentage of the fifth doping element in the selector material may be 0.01% to 20%, and may further be 0.01% to 10%.

In some examples, the fifth doping element includes at least one of an element B, an element Al, an element Ga, an element In, an element C, an element Si, an element Ge, an element Sn, an element N, an element P, an element As, an element Sb, an element Bi, and an element O, and further includes at least one of an element Au, an element Hf, an element Pd, an element Cu, an element Co, an element Ag, an element Pt, an element Sc, an element Ti, and an element Ta.

The fifth doping element is doped into the selector material, so that the selector layer 600 has advantages such as a low leakage current, strong thermal stability, and a long cycle life.

A thickness of the selector layer 600 may be 10 nm to 50 nm, for example, 1 nm, 2 nm, 3 nm, 4 nm, 5 nm, 6 nm, 7 nm, 8 nm, 9 nm, 10 nm, 15 nm, 20 nm, 25 nm, 30 nm, 35 nm, 40 nm, 45 nm or 50 nm. The thickness of the selector layer 600 may be determined based on an electrical property of the phase change storage unit connected in series to the selector layer 600, to ensure that the selector unit maintains an expected switching characteristic.

In some examples, as shown in FIG. 9 to FIG. 12, the selector unit may include only the selector layer 600, and the selector layer 600 is integrated into the phase change storage unit. The selector layer 600 and the phase change material layer 100 in the phase change storage unit are connected in series via an intermediate electrode 503.

In some examples, the selector unit is independent of a corresponding phase change storage unit (not shown in the figure). In this example, the selector unit may include a substrate, a bottom electrode, a selector layer, and a top electrode that are sequentially arranged in a stacked manner from bottom to top, and an outer side of the selector layer is further wrapped with an insulation layer. An electrode layer of the selector unit and an electrode layer of the corresponding phase change storage unit may be connected in series by using a conducting wire (for example, a copper interconnection cable) or the like.

The phase change storage chip provided in this embodiment of this disclosure may be prepared by using a thin film deposition process, a photoengraving process, an etching process, and the like. A plurality of functional layers in the phase change storage chip, for example, the phase change material layer 100, the adhesive layer 200, the barrier layer 300, and the selector layer 600, may all be prepared by using a thin film deposition process.

For example, some applicable thin film deposition processes include but are not limited to atomic layer deposition (atomic layer deposition, ALD), physical vapor deposition (Physical Vapor Deposition, PVD), chemical vapor deposition (Chemical Vapor Deposition, CVD), and the like. For further example, the foregoing functional layers may be prepared by using a plasma-enhanced chemical vapor deposition (Plasma-Enhanced Chemical Vapor Deposition, PECVD) process, a magnetron sputtering process, an electron beam evaporation process, and the like.

Magnetron sputtering is a kind of a physical vapor deposition process, and has advantages of easy control, large coating area, strong adhesive force and wide range of preparation objects. For example, in this embodiment of this disclosure, functional layers may be formed by using the magnetron sputtering process. A sputtering gas used in the magnetron sputtering process includes but is not limited to at least one of argon Ar, krypton Kr, xenon Xe, neon Ne, and nitrogen N2.

The substrate 004 in the phase change storage unit and some gating tube units includes but is not limited to a silicon dioxide substrate, a silicon carbide substrate, a silicon wafer substrate, a sapphire substrate, a diamond substrate, and the like.

Electrode materials of the electrodes (the top electrode 501, the bottom electrode 502, and the intermediate electrode 503) related to the phase change storage unit and some selector units include but are not limited to: tungsten titanium TiW (for example, Ti₃W₇), tungsten W, aluminum Al, titanium nitride TiN, tantalum Ti, tantalum Ta, silver Ag, platinum Pt, carbon C, copper Cu, ruthenium Ru, gold Au, cobalt Co, Chromium Cr, nickel Ni, iridium Ir, palladium Pd, rhodium Rh, and the like.

The electrode material may be deposited into a corresponding electrode layer by using a process like physical vapor deposition (Physical Vapor Deposition, PVD) (for example, magnetron sputtering).

The insulation layer 400 in the phase change storage unit and some selector units is configured to provide insulation and thermal isolation functions, and an insulation and thermal isolation material used by the insulation layer 400 includes but is not limited to: silicon nitride Si₃N₄, silicon carbide SiC, silicon dioxide SiO₂, and the like. The insulation and thermal isolation material may be deposited into the insulation layer 400 by using a chemical vapor deposition (Chemical Vapor Deposition, CVD) process, for example, a plasma-enhanced chemical vapor deposition (Plasma-Enhanced Chemical Vapor Deposition, PECVD) process.

In some examples, as shown in FIG. 9 to FIG. 12, the insulation layer 400 includes a first insulation layer 401 and a second insulation layer 402. The first insulation layer 401 wraps an outer side surface of at least the phase change material layer 100, and may further wrap outer side surfaces of the barrier layer 300, the adhesive layer 200, and the top electrode 501. The second insulation layer 402 wraps an outer surface of the first insulation layer 401.

For example, the first insulation layer 401 is silicon nitride Si₃N₄, silicon carbide SiC, or the like, and a thickness of the first insulation layer 401 is greater than 1 nm, for example, 2 nm to 3 nm. The second insulation layer 402 is a compound formed by the element Si and at least one of the element N, the element C, and the element O, for example, at least one of silicon nitride Si₃N₄, silicon carbide SiC, and silicon dioxide SiO₂, and a thickness of the second insulation layer 402 is greater than 1 nm, for example, 2 nm to 3 nm.

The first insulation layer 401 and the second insulation layer 402 are arranged outside of the phase change material layer 100 from inside to outside, to optimize insulation isolation and thermal isolation.

In some examples, as shown in FIG. 9 to FIG. 12, the insulation layer includes a third insulation layer 403 and a fourth insulation layer 404. The third insulation layer 403 wraps an outer side surface of at least the selector layer 600, and may further wrap outer side surfaces of the intermediate electrode 503 and the bottom electrode 502. The fourth insulation layer 404 wraps an outer side surface of the third insulation layer 403.

For example, the third insulation layer 403 is silicon nitride Si₃N₄, silicon carbide SiC, or the like, and a thickness of the third insulation layer 403 is greater than 1 nm, for example, 2 nm to 3 nm. The fourth insulation layer 404 is a compound formed by the element Si and at least one of the element N, the element C, and the element O, for example, at least one of silicon nitride Si₃N₄, silicon carbide SiC, and silicon dioxide SiO₂, and a thickness of the fourth insulation layer 404 is greater than 1 nm.

For example, a thickness of the fourth insulation layer 404 of a single-layer structure may be 2 nm to 3 nm. In some examples, the fourth insulation layer 404 may alternatively be arranged as a two-layer structure that is sequentially wrapped from inside to outside. Materials of the two layers of structures are different, a thickness of the fourth insulation layer 404 of the two-layer structure may be 2 nm to 15 nm.

The third insulation layer 403 and the fourth insulation layer 404 are arranged outside of the selector layer 600 from inside to outside, to optimize insulation isolation and thermal isolation.

A structure form of the phase change storage chip provided in this embodiment of this disclosure includes but is not limited to an 1S1R (One Selector One Resistor) structure, an 1SnR (One Selector n Resistor) structure, and the like. For a phase change storage chip of the 1S1R structure, one selector unit correspondingly controls one phase change storage unit. For a phase change storage chip of the 1SnR structure, one selector unit correspondingly controls n phase change storage units simultaneously.

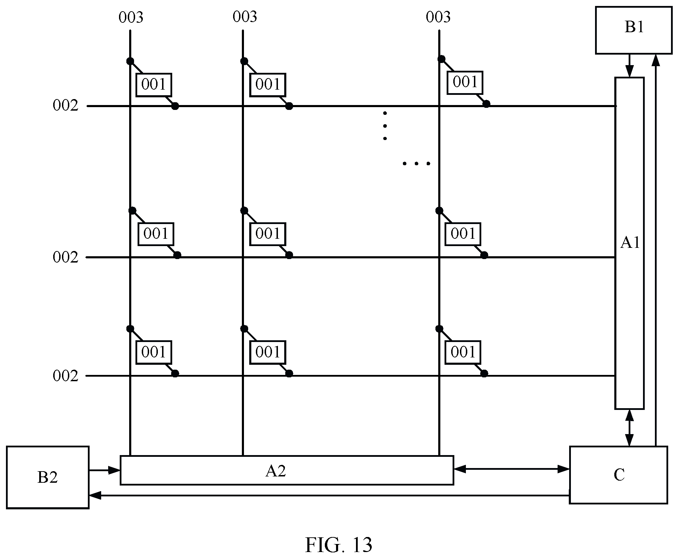

In some examples, a structure of the phase change storage chip in this embodiment of this disclosure may be the 1S1R structure, and each group of a selector unit and a phase change storage unit that are connected in series is defined as one storage subunit 001. As shown in FIG. 13, the 1S1R-type phase change storage chip includes a plurality of storage subunits 001, a plurality of word lines 002, and a plurality of bit lines 003. Certainly, the phase change storage chip further includes a peripheral control circuit.

The plurality of storage subunits 001 form a phase change memory array. The plurality of storage subunits 001 are arranged in arrays, the plurality of word lines 002 are distributed in parallel at intervals, each word line 002 may extend in a first direction, the plurality of bit lines 003 are distributed in parallel at intervals, and each bit line 003 may extend in a second direction. There is an included angle between the first direction and the second direction, and the included angle is greater than 0° and less than or equal to 90°.

For example, the included angle between the first direction and the second direction is equal to 90°, so that the plurality of word lines 002 may be sequentially arranged in rows, the plurality of bit lines 003 may be sequentially arranged in columns, and the plurality rows of word lines 002 and the plurality columns of bit lines 003 cooperate to form an array that matches the plurality of storage subunits 001. Each storage subunit 001 is located in a matrix subunit including a word line 002 and a bit line 003 (that is, located in an overlapping area between the word line 002 and the bit line 003), each storage subunit 001 is connected to a bit line 003 in a corresponding column via a top electrode 501 of the storage subunit 001, and each storage subunit 001 is connected to a word line 002 in a corresponding row via a bottom electrode 502 of the storage subunit 001.

In application, the plurality of word lines 002 arranged in rows are connected to a row selection circuit A1, and the row selection circuitA1 can be further driven by a row voltage control circuit B1; and the plurality of bit lines 003 arranged in columns are connected to a column selection circuit A2, and the column selection circuit A2 can be further driven by a column voltage control circuit B2. A read/write circuit C is separately connected to the row voltage control circuit B1 or the column voltage control circuit B2 by receiving a command of a processor. In this way, the read/write circuit C controls the row selection circuit A1 or the column selection circuit A2 by receiving the command of the processor via the row voltage control circuit B1 or the column voltage control circuit B2, to perform a read/write operation on the phase change storage unit in the selected storage subunit 001.

In a process of performing the read/write operation on the phase change storage unit, a selector unit is used as a switch component. When a storage subunit 001 is not selected by both the row selection circuit A1 and the column selection circuit A2, a selector unit corresponding to the storage subunit 001 is in an off state, to avoid impact of a leakage current on another unit.

According to the phase change storage chip provided in this embodiment of this disclosure, three-dimensional stacking may be performed on the phase change memory chip, to form an N-layer structure (N≥1) in a vertical direction, so that a storage density of a three-dimensional stacked memory reaches 4F²*N, where F is a semiconductor process feature size.

The following describes, with reference to a solution in which the phase change storage chip includes a selector layer 600 and the selector layer 600 is integrated into the phase change storage unit, structures of some phase change storage chips provided in embodiments of this disclosure by using examples.

In an example 1, FIG. 9 shows a 1S1R-type phase change storage chip. The phase change storage chip is arranged on a substrate 004, the 1S1R-type phase change storage chip includes a plurality of storage subunits 001, a plurality of word lines 002, and a plurality of bit lines 003. The plurality of storage subunits 001 are arranged in arrays, the plurality of word lines 002 are sequentially arranged in rows, and the plurality of bit lines 003 are sequentially arranged in columns. Each storage subunit 001 is connected to a bit line 003 in a corresponding column via a top electrode 501 of the storage subunit 001, and each storage subunit 001 is connected to a word line 002 in a corresponding row via a bottom electrode 502 of the storage subunit 001.

Each storage subunit 001 includes a bottom electrode 502, a selector layer 600, an intermediate electrode 503, a barrier layer 300, a phase change material layer 100, a barrier layer 300, and a top electrode 501 that are sequentially arranged in a stacked manner from bottom to top. Adjacent storage subunits 001 are isolated from each other via an insulation layer. Specifically, for each storage subunit 001, outer side surfaces of the barrier layer 300, the phase change material layer 100, the barrier layer 300, and the top electrode 501 are sequentially wrapped with a first insulation layer 401 and a second insulation layer 402 from inside to outside, and outer side surfaces of the bottom electrode 502, the selector layer 600, and the intermediate electrode 503 are sequentially wrapped with a third insulation layer 403 and a fourth insulation layer 404 from inside to outside.

In the phase change storage chip provided in Example 1, the phase change material layer 100 of the phase change storage chip uses the improved phase change material provided in the foregoing embodiment of this disclosure, so that an adhesive force between the phase change material layer 100 and the barrier layer 300 can be effectively improved.

In an example 2, FIG. 10 shows a 1S1R-type phase change storage chip. The phase change storage chip is arranged on a substrate 004, the 1S1R-type phase change storage chip includes a plurality of storage subunits 001, a plurality of word lines 002, and a plurality of bit lines 003. The plurality of storage subunits 001 are arranged in arrays, the plurality of word lines 002 are sequentially arranged in rows, and the plurality of bit lines 003 are sequentially arranged in columns. Each storage subunit 001 is connected to a bit line 003 in a corresponding column via a top electrode 501 of the storage subunit 001, and each storage subunit 001 is connected to a word line 002 in a corresponding row via a bottom electrode 502 of the storage subunit 001.

Each storage subunit 001 includes a bottom electrode 502, a selector layer 600, an intermediate electrode 503, a barrier layer 300, an adhesive layer 200, a phase change material layer 100, an adhesive layer 200, a barrier layer 300, and a top electrode 501 that are sequentially arranged in a stacked manner from bottom to top. Adjacent storage subunits 001 are isolated from each other via an insulation layer. Specifically, for each storage subunit 001, outer side surfaces of the barrier layer 300, the adhesive layer 200, the phase change material layer 100, the adhesive layer 200, the barrier layer 300, and the top electrode 501 are sequentially wrapped with a first insulation layer 401 and a second insulation layer 402 from inside to outside, and outer side surfaces of the bottom electrode 502, the selector layer 600, and the intermediate electrode 503 are sequentially wrapped with a third insulation layer 403 and a fourth insulation layer 404 from inside to outside.

In the phase change storage chip provided in Example 2, the phase change material layer 100 of the phase change storage chip uses the improved phase change material provided in the foregoing embodiments of this disclosure, in addition, the adhesive layer 200 is added between the phase change material layer 100 and the barrier layer 300, so that an adhesive force between the phase change material layer 100 and the barrier layer 300 can be further improved.

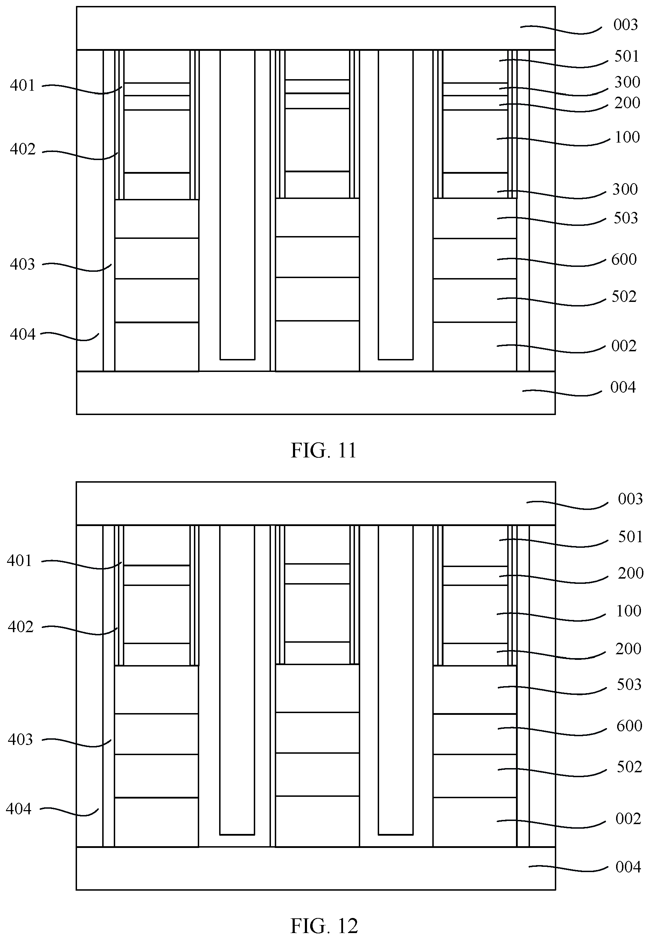

In an example 3, FIG. 11 shows a 1S1R-type phase change storage chip. The phase change storage chip is arranged on a substrate 004, the 1S1R-type phase change storage chip includes a plurality of storage subunits 001, a plurality of word lines 002, and a plurality of bit lines 003. The plurality of storage subunits 001 are arranged in arrays, the plurality of word lines 002 are sequentially arranged in rows, and the plurality of bit lines 003 are sequentially arranged in columns. Each storage subunit 001 is connected to a bit line 003 in a corresponding column via a top electrode 501 of the storage subunit 001, and each storage subunit 001 is connected to a word line 002 in a corresponding row via a bottom electrode 502 of the storage subunit 001.

Each storage subunit 001 includes a bottom electrode 502, a selector layer 600, an intermediate electrode 503, a barrier layer 300, a phase change material layer 100, an adhesive layer 200, a barrier layer 300, and a top electrode 501 that are sequentially arranged in a stacked manner from bottom to top. Adjacent storage subunits 001 are isolated from each other via an insulation layer. Specifically, for each storage subunit 001, outer side surfaces of the barrier layer 300, the phase change material layer 100, the adhesive layer 200, the barrier layer 300, and the top electrode 501 are sequentially wrapped with a first insulation layer 401 and a second insulation layer 402 from inside to outside, and outer side surfaces of the bottom electrode 502, the selector layer 600, and the intermediate electrode 503 are sequentially wrapped with a third insulation layer 403 and a fourth insulation layer 404 from inside to outside.

In the phase change storage chip provided in Example 3, the phase change material layer 100 of the phase change storage chip uses the improved phase change material provided in the foregoing embodiments of this disclosure, in addition, the adhesive layer 200 is added to a side that is of the phase change material layer 100 and that is close to the top electrode 501, so that an adhesive force between the phase change material layer 100 and the barrier layer 300 can be further improved.

Certainly, in the phase change storage chip provided in Example 3, the adhesive layer 200 may alternatively be added to a side that is of the phase change material layer 100 and that is close to the selector layer 600, to increase a bonding force between the phase change material layer 100 and the barrier layer 300 that is close to the selector layer 600.

As an example 4, FIG. 12 shows a 1S1R-type phase change storage chip. The phase change storage chip is arranged on a substrate 004, the 1S1R-type phase change storage chip includes a plurality of storage subunits 001, a plurality of word lines 002, and a plurality of bit lines 003. The plurality of storage subunits 001 are arranged in arrays, the plurality of word lines 002 are sequentially arranged in rows, and the plurality of bit lines 003 are sequentially arranged in columns. Each storage subunit 001 is connected to a bit line 003 in a corresponding column via a top electrode 501 of the storage subunit 001, and each storage subunit 001 is connected to a word line 002 in a corresponding row via a bottom electrode 502 of the storage subunit 001.

Each storage subunit 001 includes a bottom electrode 502, a selector layer 600, an intermediate electrode 503, an adhesive layer 200, a phase change material layer 100, an adhesive layer 200, and a top electrode 501 that are sequentially arranged in a stacked manner from bottom to top. Adjacent storage subunits 001 are isolated from each other via an insulation layer. Specifically, for each storage subunit 001, outer side surfaces of the adhesive layer 200, the phase change material layer 100, the adhesive layer 200, and the top electrode 501 are sequentially wrapped with a first insulation layer 401 and a second insulation layer 402 from inside to outside, and outer side surfaces of the bottom electrode 502, the selector layer 600, and the intermediate electrode 503 are sequentially wrapped with a third insulation layer 403 and a fourth insulation layer 404 from inside to outside.

In the phase change storage chip provided in Example 4, the phase change material layer 100 of the phase change storage chip uses the improved phase change material provided in the foregoing embodiments of this disclosure, in addition, the adhesive layer 200 is added between the phase change material layer 100 and the electrode layer, so that an adhesive force between the phase change material layer 100 and the electrode layer can be further improved.

In embodiments of this disclosure, with reference to any one of the foregoing phase change materials, structure arrangement and preparation processes of some 1S1R-type phase change storage chips are described as examples.

As an instance (1), such a 1S1R-type phase change storage chip is provided, and is arranged on a silicon oxide substrate 004. The 1S1R-type phase change storage chip includes a plurality of storage subunits 001, a plurality of word lines 002, and a plurality of bit lines 003. As shown in FIG. 9, each storage subunit 001 includes a bottom electrode 502, a selector layer 600, an intermediate electrode 503, a barrier layer 300, a phase change material layer 100, a barrier layer 300, and a top electrode 501 that are sequentially arranged in a stacked manner from bottom to top, and adjacent storage subunits 001 are isolated from each other via an insulation layer. The plurality of storage subunits 001 are arranged in arrays, the plurality of word lines 002 are sequentially arranged in rows, and the plurality of bit lines 003 are sequentially arranged in columns. Each storage subunit 001 is connected to a bit line 003 in a corresponding column via a top electrode 501 of the storage subunit 001, and each storage subunit 001 is connected to a word line 002 in a corresponding row via a bottom electrode 502 of the storage subunit 001.

For example, materials of the word line 002 and the bit line 003 are all metal tungsten W, materials of the top electrode 501, the bottom electrode 502, and the intermediate electrode 503 are all carbon C, and a material of the barrier layer 300 is metal tungsten W. A selector material used by the selector layer 600 is a currently sold SiGeAsSe gating material. A phase change material of the phase change material layer 100 may be the phase change material in the foregoing first embodiment.

A preparation process of the 1S1R-type phase change storage chip is shown as follows.

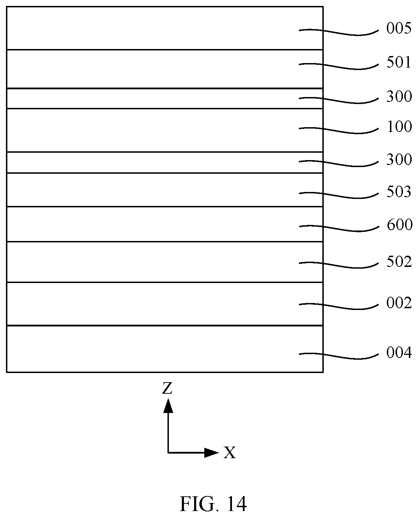

As shown in FIG. 14, a thin film precursor of a phase change storage chip is provided. The thin film precursor includes: a substrate 004, a word line 002 layer, a bottom electrode 502, a selector layer 600, an intermediate electrode 503, a barrier layer 300, a phase change material layer 100, a barrier layer 300, a top electrode 501, and a mask layer 005 that are sequentially arranged in a stacked manner from bottom to top. The mask layer 005 is mainly configured to protect the material layers below the mask layer 005, to prevent a process like etching from affecting the material layers below the mask layer 005.

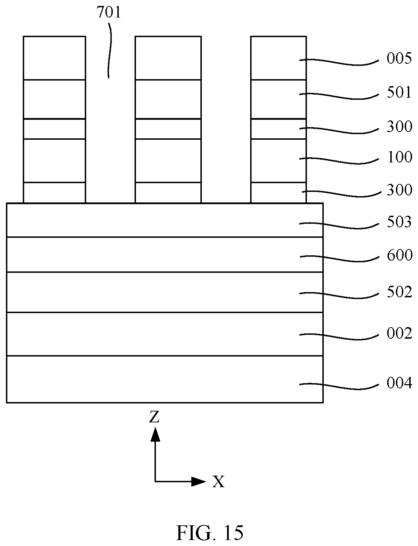

As shown in FIG. 15, first patterning processing is performed on the thin film precursor, to form a first groove 701. The first patterning processing includes photoengraving processing and etching processing. In a vertical direction (that is, a Z-axis direction in FIG. 15), the first groove 701 sequentially penetrates the mask layer 005, the top electrode 501, the barrier layer 300, the phase change material layer 100, and the barrier layer 300 from top to bottom, to expose the intermediate electrode 503. In a first horizontal direction (that is, an X-axis direction in FIG. 15), a plurality of first grooves 701 are arranged at intervals to form a plurality of first storage unit precursors.

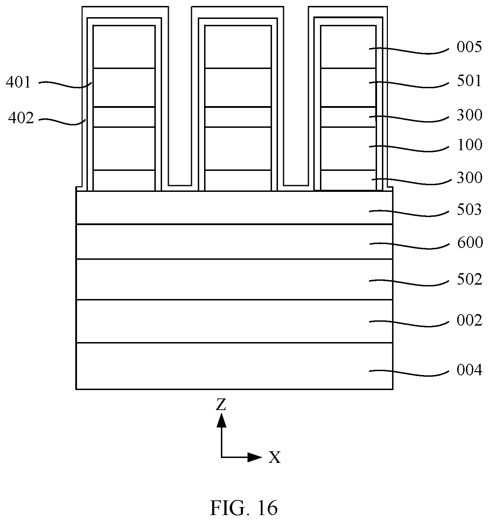

As shown in FIG. 16, the first groove 701 is filled with an insulation material, to form an insulation layer. This includes: sequentially filling the first groove 701 with a first insulation material and a second insulation material, where the first insulation material forms a first insulation layer 401 and wraps a surface of a corresponding first storage unit precursor, and the second insulation material forms a second insulation layer 402 and wraps a surface of the first insulation layer 401. A material of the first insulation layer 401 is silicon nitride, and a material of the second insulation layer 402 is silicon dioxide. The first insulation layer 401 and the second insulation layer 402 can prevent the phase change material layer 100 from being affected by a subsequent etching process.

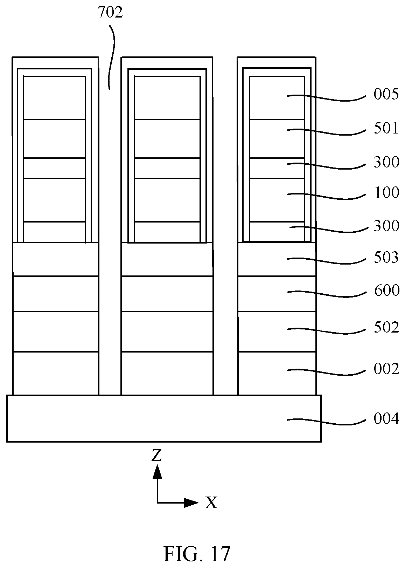

As shown in FIG. 17, second patterning processing continues to be performed, so that the first groove 701 extends downward in a vertical direction, to form a second groove 702. The second patterning processing includes photoengraving processing and etching processing.

In the vertical direction, the second groove 702 sequentially penetrates the mask layer 005, the top electrode 501, the barrier layer 300, the phase change material layer 100, the barrier layer 300, the intermediate electrode 503, the selector layer 600, the bottom electrode 502, and the word line 002 from top to bottom. In a first horizontal direction, a plurality of second grooves 702 are arranged at intervals to form a plurality of second storage unit precursors.

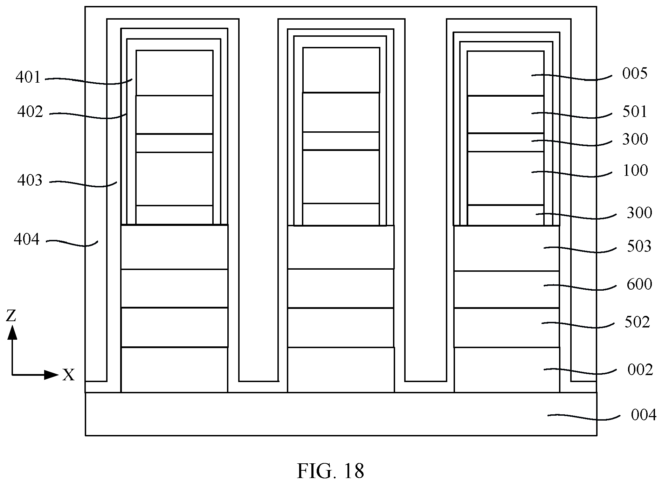

As shown in FIG. 18, filling the second groove 702 with an insulation material to form an insulation layer includes: sequentially filling the second groove 702 with a third insulation material and a fourth insulation material, where the third insulation material forms a third insulation layer 403 and wraps a surface of a corresponding second storage unit precursor, and the fourth insulation material forms a fourth insulation layer 404 and wraps a surface of the third insulation layer 403, to obtain an integrated third storage unit precursor. A material of the third insulation layer 403 is silicon nitride, and a material of the fourth insulation layer 404 is silicon dioxide. The third insulation layer 403 and the fourth insulation layer 404 perform insulation isolation between different second storage unit precursors, and can further provide mechanical support for the second storage unit precursors.

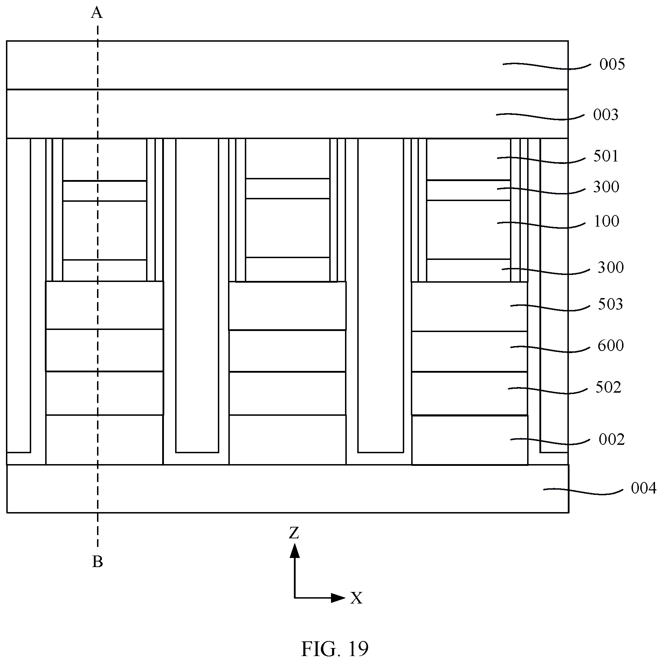

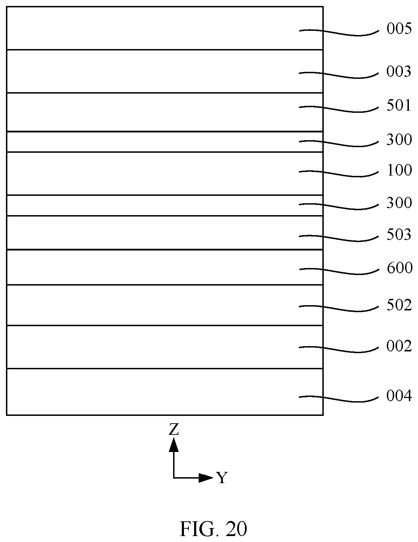

As shown in FIG. 19, polishing processing is performed on the third storage unit precursor, to remove the mask layer 005 and expose the top electrode 501. Then, the bit line 003 and a new mask layer 005 are sequentially formed on a surface of the top electrode 501, to obtain an integrated fourth storage unit precursor. A structure of a cross section of the fourth storage unit precursor along a second horizontal direction is shown in FIG. 20. The cross section along the second horizontal direction is a cross section shown by a dashed line AB in FIG. 19, and the second horizontal direction is a Y-axis direction in FIG. 20 and is perpendicular to the foregoing X-axis direction.

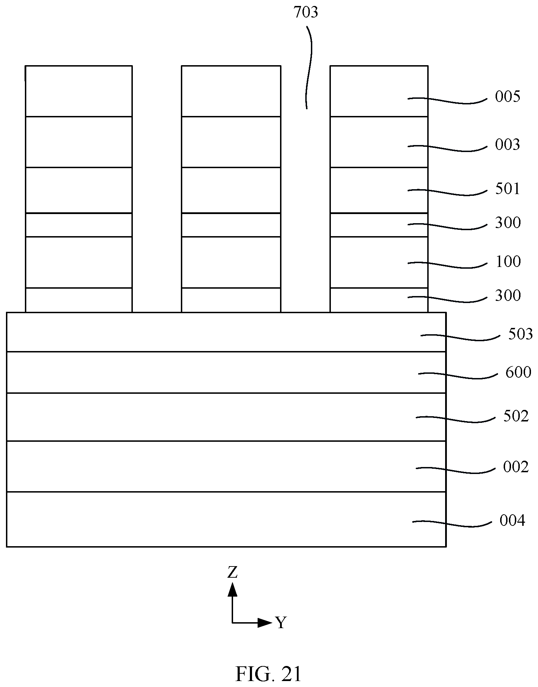

As shown in FIG. 21, third patterning processing is performed on the fourth storage unit precursor to form a third groove 703. The third patterning processing includes photoengraving processing and etching processing. In a vertical direction, the third groove 703 sequentially penetrates the mask layer 005, the bit line 003 layer, the top electrode 501, the barrier layer 300, the phase change material layer 100, and the barrier layer 300 from top to bottom, to expose the intermediate electrode 503. In the second horizontal direction, a plurality of third grooves 703 are arranged at intervals to form a plurality of fifth storage unit precursors.

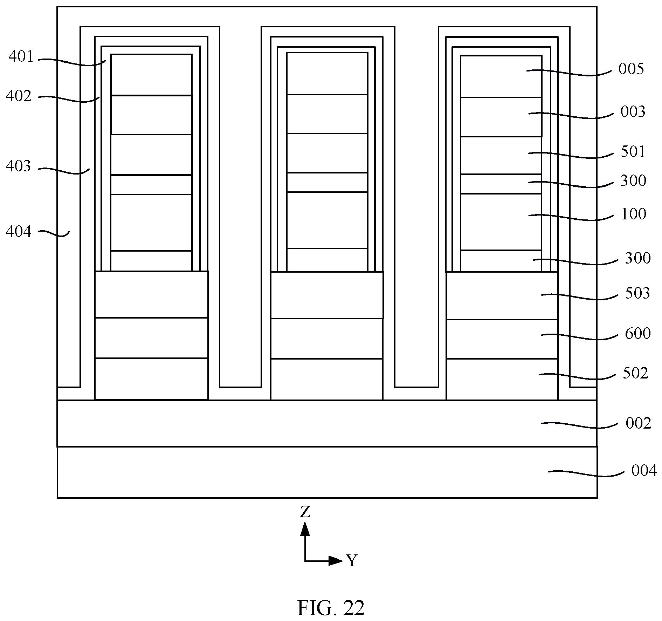

As shown in FIG. 22, filling the third groove 703 with an insulation material to form an insulation layer includes: sequentially filling the third groove 703 with a first insulation material and a second insulation material, where the first insulation material forms a first insulation layer 401 and wraps a corresponding surface of the fifth storage unit precursor, and the second insulation material forms a second insulation layer 402 and wraps a surface of the first insulation layer 401, to obtain an integrated sixth storage unit precursor.

Further, as shown in FIG. 22, fourth patterning processing continues to be performed on the sixth storage unit precursor, so that the third groove 703 extends downward in a vertical direction to form a fourth groove. The fourth patterning processing includes photoengraving processing and etching processing. In the vertical direction, the fourth groove sequentially penetrates the mask layer 005, the bit line 003 layer, the top electrode 501, the barrier layer 300, the phase change material layer 100, the barrier layer 300, the intermediate electrode 503, the selector layer 600, and the bottom electrode 502 from top to bottom, to expose the word line 002. In the second horizontal direction, a plurality of fourth grooves are arranged at intervals to form a plurality of seventh storage unit precursors.

As shown in FIG. 22, filling the fourth groove with an insulation material to form an insulation layer includes: sequentially filling the fourth groove with a third insulation material and a fourth insulation material, where the third insulation material forms a third insulation layer 403 and wraps a corresponding surface of a seventh storage unit precursor, and the fourth insulation material forms a fourth insulation layer 404 and wraps a surface of the third insulation layer 403, to obtain an integrated eighth storage unit precursor.

As shown in FIG. 23, polishing processing is performed on the eighth storage unit precursor to remove the third insulation layer 403 and the fourth insulation layer 404 that are above the mask layer 005 and the bit line 003, to expose the bit line 003, to prepare the phase change storage chip provided in Embodiment 1.

According to the phase change storage chip provided in Embodiment 1, the phase change material is improved, so that a bonding force between the phase change material layer 100 and the barrier layer 300 is effectively improved, and a yield of the phase change storage chip does not decrease due to delamination or falling off between layers. In addition, the improved phase change material still helps enable the phase change storage chip to have advantages of characteristics such as a large read window, a low delay, and a long life.

For the phase change storage chip in this type of instance, the phase change material is improved, so that the bonding force between the phase change material layer 100 and the barrier layer 300 is effectively improved, and the yield of the phase change storage chip does not decrease due to delamination or falling off between layers. In addition, the improved phase change material still helps enable the phase change storage chip to have advantages of characteristics such as a large read window, a low delay, and a long life.

As an instance (2), such a 1S1R-type phase change storage chip is provided. The 1S1R-type phase change storage chip in this type of instance includes a plurality of storage subunits 001, a plurality of word lines 002, and a plurality of bit lines 003. As shown in FIG. 10, each storage subunit 001 includes a bottom electrode 502, a selector layer 600, an intermediate electrode 503, a barrier layer 300, an adhesive layer 200, a phase change material layer 100, an adhesive layer 200, a barrier layer 300, and a top electrode 501 that are sequentially arranged in a stacked manner from bottom to top, and adjacent storage subunits 001 are isolated from each other via an insulation layer. In comparison with the instance (1), the adhesive layer 200 is added to the storage subunit 001, and arrangements of other layers are the same. For example, a thickness of the adhesive layer 200 may be 2 nm, and a material of the adhesive layer 200 may be WN or InGeSbTe. WN may be W₂N, WN, WN₂, or any component that meets the following formula: WₓN₁₋ₓ, where x is an atomic percentage, and 0<x<1. The InGeSbTe compound may be, for example, In3%-Ge2Sb2Te5, that is, an atomic percentage of In is 3%, and in a GeSbTe phase change base material, a ratio between atomic percentage content of Ge, Sb, and Te is 2:2:5.

For a preparation process of the phase change storage chip in this type of instance (2), refer to the foregoing instance (1). A difference lies in that when the storage subunit 001 is formed, the adhesive layer 200 is formed at a specific position.

In the phase change storage chip in this type of instance (2), the phase change material is improved, in addition, the adhesive layer 200 is added between the phase change material layer 100 and the barrier layer 300, so that a bonding force between the phase change material layer 100 and the barrier layer 300 is effectively improved. In addition, because a total thickness of the two adhesive layers 200 may be 4 nm, and is only one tenth of a thickness of the phase change material layer 100, impact on performance of the phase change material layer 100 is small.

As an instance (3), such a 1S1R-type phase change storage chip is provided. For a structure and a preparation process of the 1S1R-type phase change storage chip, refer to the instance (1). A difference between the phase change storage chip in the instance (3) and the phase change storage chip in the instance (1) lies in that: Refer to FIG. 12, and the barrier layer 300 in Embodiment 1 is directly replaced with an adhesive layer 200, that is, the adhesive layer 200 is directly arranged between the phase change material layer 100 and the top electrode 501, and between the phase change material layer 100 and the intermediate electrode 503 separately.

In the phase change storage chip in this type of instance (3), the phase change material is improved, in addition, the adhesive layer 200 is added between the phase change material layer 100 and the electrode layer, and a bonding force between the phase change material layer 100 and the electrode layer is increased via the adhesive layer 200.

As an instance (4), such a 1S1R-type phase change storage chip is provided. For a structure and a preparation process of the 1S1R-type phase change storage chip, refer to the instance (1). A difference between the phase change storage chip in the instance (4) and the phase change storage chip in the instance (1) lies in that: Doping elements in the phase change material used by the phase change material layer 100 are limited to be an element Hf and an element In.

As an instance (5), such a 1S1R-type phase change storage chip is provided. For a structure and a preparation process of the 1S1R-type phase change storage chip, refer to the instance (1). A difference between the phase change storage chip in the instance (5) and the phase change storage chip in the instance (1) lies in that: The phase change material of the phase change material layer 100 may be the phase change material in the second embodiment.

In the 1S1R-type phase change storage chip in the instance (5), characteristics of a delay, a life, high resistance, low resistance, and the like of phase change storage chips in which a ratio between atomic percentage content of atoms in a Ge-Sb-Te phase change base material is: Ge:Sb:Te=1:4:7 (GST147 for short) are tested. For test results, refer to Table 5, where NA in Table 5 refers to that data does not exist.

**Table 5**

| Element Hf and an atomic percentage of the element Hf/% | Element N and an atomic percentage of the element N/% | Ge-Sb-Te Phase change base material | 1R delay | 1R normal life (electrical pulse width 40 ns) | Component high resistance Rrst | Component low resistance Rset | Cycle stability |
|---|---|---|---|---|---|---|---|
| 2 | 2 | GST147 | / | 1E5 | 1.2 M | 8 k | Stable |
| 4 | 0 | GST147 | 80 ns | 1E5 to 1E6 | 1 M | 25 k | Stable |
| 0 | 8 | GST147 | NA | NA | 4 M | 100 k | Low resistance is unstable |
| 8 | 0 | GST147 | NA | NA | 200 k | 50 k | High resistance is unstable |
| 6.5 | 5 | GST147 | NA | NA | 500 k | 100 k | High resistance and low resistance are unstable |

It is proved through experiments that when an atomic percentage of Sb in the Ge-Sb-Te phase change base material is greater than 35% and less than 45%, the delay of the phase change storage chip can be less than 100 ns; and when atomic percentage content of Sb in the Ge-Sb-Te phase change base material exceeds 45%, the life of the phase change storage chip is reduced to some extent. When an atomic percentage of an element Ge is greater than 15%, the delay of the phase change storage chip is slowed down to some extent. When the atomic percentage of the Ge is less than 6%, an adhesive force of the phase change material layer is reduced.

As shown in Table 5, a sum of the atomic percentage of the element Hf and the atomic percentage of the element N is greater than 4%, which is very necessary to grant a long life characteristic to the phase change storage chip. When the atomic percentage of the element Hf is 6.5% and the atomic percentage of the element N is 5%, because the sum of the atomic percentages of the two elements is greater than 10%, the low resistance increases abnormally and is unstable in a cycle procedure.

As shown in Table 5, when the atomic percentage of the element Hf is 8%, the high resistance of the phase change storage chip becomes low and is unstable in a cycle. When the atomic percentage of the element N is 8%, the low resistance of the phase change storage chip is unstable in the cycle although the low resistance becomes higher.

The phase change storage chip provided in this embodiment of this disclosure has a potential to replace a solid-state drive (Solid-State Drive, SSD) based on a high speed, a high density, and a non-volatile characteristic of the phase change storage chip. If an operation speed is further improved, the phase change storage chip has potential to be used in a universal memory, and has functions of both an internal memory and an external memory.

According to another aspect, an embodiment of this disclosure further provides a storage device. The storage device includes a controller and any one of the foregoing phase change storage chips. The controller is configured to store data into the phase change storage chip. The controller reads and writes the data stored in the storage device, and performs interaction and communication with an external interface.

The storage device (which may also be referred to as a memory) may be configured to store various types of data. The data may be contact data, phone book data, a message, a picture, a video, or the like, or may be instruction data.

The storage device in embodiments of this disclosure may be set to various types, for example, including but not limited to an internal memory, a hard disk, a magnetic disk, and an optical disc.

An embodiment of this disclosure further provides an electronic device. The electronic device includes a processor and the foregoing storage device, and the processor is configured to store data generated by the electronic device into the storage device.

In some examples, the electronic device includes but is not limited to: a computer, a mobile phone, a music play device, a digital broadcasting device, a message transceiver device, a game control device, a medical device, a fitness device, a personal digital assistant, and the like.

The foregoing descriptions are merely intended to help a person skilled in the art understand the technical solutions of this disclosure, and are not intended to limit this disclosure. Any modification, equivalent replacement, or improvement made without departing from the spirit and principle of this disclosure shall fall within the protection scope of this disclosure.

## Claims

1. A phase change material, wherein the phase change material comprises a Ge-Sb-Te phase change base material, and a first doping element and a second doping element that are doped into the Ge-Sb-Te phase change base material;
the first doping element comprises an element Hf, and an atomic percentage of the first doping element in the phase change material is 1.5% to 6.5%; and
the second doping element comprises at least one of an element N, an element C, an element In, or an element Ga, and an atomic percentage of the second doping element in the phase change material is 1.0% to 5%.

2. The phase change material according to claim 1, wherein the phase change material further comprises a third doping element, and the third doping element comprises at least one of an element O, an element Si, an element B, an element Sn, an element Bi, an element Cd, an element Pb, an element Zr, an element Zn, an element Cr, an element Al, an element Sc, an element Y, an element Ta, an element Ti, an element Er, an element Lu, an element Ho, an element Tm, an element Dy, an element Tb, an element Ca, an element Nd, an element Pr, an element Yb, an element Ca, and an element Ce.

3. The phase change material according to either of claims 1 and 2, wherein a chemical formula of the Ge-Sb-Te phase change base material is as follows: (GeTe₁₋ₐ)ₓ(Sb₂Te_{3-b})₁₋ₓ, wherein x is an atomic percentage and 0<x<1, a and b are parameters related to an atomic quantity ratio, 0<a≤1, 0<b≤3, and a=1 and b=3 do not coexist; or
(GeTe_{1-c})ₓ(Sb_{y}Te_{1-d})₁₋ₓ, wherein x is an atomic percentage and 0<x<1, y, c, and d are parameters related to an atomic quantity ratio, y≥2, 0<c≤1, 0<d≤1, and c=1 and d=1 do not coexist.

4. A phase change material, wherein the phase change material comprises a Ge-Sb-Te phase change base material, and a first doping element and a second doping element that are doped into the Ge-Sb-Te phase change base material;
the first doping element comprises an element Hf, and an atomic percentage of the first doping element in the phase change material is 1.5% to 7%;
the second doping element comprises at least one of an element N, an element C, an element In, and an element Ga, and an atomic percentage of the second doping element in the phase change material is 1.0% to 7%; and
a sum of the atomic percentage of the first doping element and the atomic percentage of the second doping element is greater than 4% and less than 10%.

5. The phase change material according to claim 4, wherein the phase change material further comprises a third doping element, and the third doping element comprises at least one of an element O, an element Si, an element B, an element Sn, an element Bi, an element Cd, an element Pb, an element Zr, an element Zn, an element Cr, an element Al, an element Sc, an element Y, an element Ta, an element Ti, an element Er, an element Lu, an element Ho, an element Tm, an element Dy, an element Tb, an element Ca, an element Nd, an element Pr, an element Yb, an element Ca, and an element Ce.

6. The phase change material according to either of claims 4 and 5, wherein a chemical formula of the Ge-Sb-Te phase change base material is as follows: (GeTe₁₋ₐ)ₓ(Sb₂Te_{3-b})₁₋ₓ, wherein x is an atomic percentage and 0<x<1, a and b are parameters related to an atomic quantity ratio, 0<a≤1, 0<b≤3, and a=1 and b=3 do not coexist; or
(GeTe_{1-c})ₓ(Sb_{y}Te_{1-d})₁₋ₓ, wherein x is an atomic percentage and 0<x<1, y, c, and d are parameters related to an atomic quantity ratio, y≥2, 0<c≤1, 0<d≤1, and c=1 and d=1 do not coexist.

7. The phase change material according to claim 6, wherein a chemical formula of the Ge-Sb-Te phase change base material is as follows: (GeTe₁₋ₐ)ₓ(Sb₂Te_{3-b})₁₋ₓ, and 0.2<x≤0.4, or (GeTe_{1-c})ₓ(Sb_{y}Te_{1-d})₁₋ₓ and 0.2<x≤0.4.

8. A phase change storage chip, wherein the phase change storage chip comprises a plurality of phase change storage units, the phase change storage unit comprises a phase change material layer, and the phase change material layer is prepared by using the phase change material according to any one of claims 1 to 3, or the phase change material layer is prepared by using the phase change material according to any one of claims 4 to 7.

9. The phase change storage chip according to claim 8, wherein the phase change storage unit further comprises an adhesive layer, the adhesive layer is arranged on at least one surface of the phase change material layer in a stacked manner, and the adhesive layer is configured to increase an adhesive force between the phase change material layer and a neighboring functional layer.

10. The phase change storage chip according to claim 9, wherein an adhesive layer raw material used by the adhesive layer comprises at least one of a nitride of a target element and a carbide of the target element; and
the target element is selected from at least one of an element W, an element Ti, an element Ge, an element Ta, an element Hf, an element In, an element Ga, an element Al, an element Cu, an element Co, and an element Mo.

11. The phase change storage chip according to claim 9, wherein an adhesive layer raw material used by the adhesive layer comprises a Ge-Sb-Te phase change material doped with a fourth doping element, and the adhesive layer raw material is different from the phase change material; and
the fourth doping element is selected from at least one of an element Hf, an element N, an element C, an element In, and an element Ga, and an atomic percentage of the fourth doping element in the adhesive layer raw material is 0.01% to 20%.

12. The phase change storage chip according to any one of claims 9 to 11, wherein the phase change storage unit further comprises a barrier layer, and the adhesive layer is located between the phase change material layer and the barrier layer and is configured to increase an adhesive force between the phase change material layer and the barrier layer.

13. The phase change storage chip according to claim 12, wherein a barrier layer material used by the barrier layer comprises at least one of single element materials, nitrides, and carbides of an element W, an element Ti, an element Ge, an element Ta, an element Hf, an element In, an element Ga, an element Al, an element Cu, an element Co, and an element Mo.

14. The phase change storage chip according to any one of claims 9 to 11, wherein the phase change storage unit further comprises an electrode layer, and the adhesive layer is located between the phase change material layer and the electrode layer and is configured to increase an adhesive force between the phase change material layer and the electrode layer.

15. The phase change storage chip according to any one of claims 8 to 14, wherein the phase change storage chip further comprises a plurality of selector units, and the selector unit and the phase change storage unit are arranged in series; and
the selector unit comprises a selector layer, and a selector material used by the selector layer comprises at least one of an S-series selector material, an Se-series selector material, and a Te-series selector material.

16. The phase change storage chip according to claim 15, wherein the selector material further comprises a fifth doping element, and the fifth doping element is selected from at least one of an element B, an element Al, an element Ga, an element In, an element C, an element Si, an element Ge, an element Sn, an element N, an element P, an element As, an element Sb, an element Bi, an element O, an element Au, an element Hf, an element Pd, an element Cu, an element Co, an element Ag, an element Pt, an element Sc, an element Ti, and an element Ta.

17. A storage device, wherein the storage device comprises a controller and at least one phase change storage chip according to any one of claims 8 to 16, and the controller is configured to store data into the phase change storage chip.

18. An electronic device, wherein the electronic device comprises a processor and the storage device according to claim 17, and the processor is configured to store data generated by the electronic device into the storage device.
